# EUROPEAN PATENT SPECIFICATION

(11) **EP 4 571 328 B1**
(45) Date of publication and mention of the grant of the patent: **11.11.2026**
(21) Application number: 24190536.3
(22) Date of filing: 24.07.2024
(51) Int. Cl.: G01R 29/08, G01V 3/06

(54) **UNDERGROUND CABLE PATH TESTER**
UNTERIRDISCHER KABELWEGTESTER
TESTEUR DE CHEMIN DE CÂBLE SOUTERRAIN

(30) Priority: 15.12.2023 CN 202323432162 U; 18.12.2023 CN 202323452119 U
(43) Date of publication of application: 18.06.2025
(73) Proprietor: Yongzhou Noyafa Electronic Co., Ltd., Yongzhou, Hunan 425000 (CN)
(72) Inventor: LEI, Ming, Yongzhou, 425000 (CN); ZHANG, Jianping, Yongzhou, 425000 (CN)
(74) Representative: Santarelli

(56) References cited:
- CN-U- 209 231 530
- CN-U- 212 514 952
- CN-Y- 2 795 876
- CN-Y- 2 896 306
- US-A- 5 194 812
- US-A- 5 361 029
- US-A- 6 140 819
- US-A- 6 163 144
- US-A1- 2004 174 153
- US-A1- 2008 309 315

## Description

### Technical Field

Disclosed in the present disclosure is an underground cable path finding device and particularly an underground cable path tester.

### Background of the Invention

With the development of urbanization, all kinds of cables and pipelines are wired in a buried way, which renders the pipelines denser and more complex. Some cities have a long history of power grid construction, especially in some central and old urban areas, in which the medium and low-voltage power grid distribution capacity is insufficient.

How to find out the path of age-old power grid cables has become a necessary consideration for power grid renovation and construction. Existing technology requires that the low-voltage power grid must not be electrified for cable path detection, and the instrument is bulky, requires multiple operators, and needs to find the ends of the target cable to determine the path, which undoubtedly brings certain limitations to the power grid renovation and construction. US 5361029A1 discloses a locator system that uses a transmitter to simultaneously couple signals of different frequencies to multiple underground lines and a receiver to detect and distinguish between these frequencies, enabling concurrent location and identification of multiple concealed objects.

### Summary of the Invention

In view of the above mentioned deficiencies of the prior art in which ordinary cable path testers are unable to determine the path of a cable line in an electrified condition, provided in the present disclosure is an underground cable path tester, which adds a set frequency signal to the power grid and receives and amplifies it through a receiving probe, so as to test the path of underground cables.

The invention is set out in the appended set of claims.

The beneficial effects of the present disclosure are as follows. The present disclosure allows a set frequency signal to be added to the power grid, by receiving and amplifying the probe signal, testing the underground cable path, regardless of whether the underground cable is electrified or not, the cable path is detectable, and the primary unit and the secondary unit adopt a small and compact structural design, which solves the deficiencies of the previous need for bulky instruments and equipment, multi-person operation and the need to find the ends of the target cable in order to determine the path.

The present disclosure is further described below in conjunction with the attached drawings and the specific implementations.

### Brief description of the Drawings

Fig. 1 is a circuit block diagram of the present invention when the first signal processing device is the signal transmitting module.
Fig. 2 is a circuit diagram of the primary unit central control module of the present invention when the first signal processing device is the signal transmitting module.
Fig. 3 is a circuit diagram of the primary unit power module of the present invention when the first signal processing device is the signal transmitting module.
Fig. 4 is a circuit diagram of the primary unit charging module of the present invention when the first signal processing device is the signal transmitting module.
Fig. 5 is a circuit diagram of the primary unit work indicator module of the present invention when the first signal processing device is the signal transmitting module.
Fig. 6 is a circuit diagram of the primary unit display module of the present invention when the first signal processing device is the signal transmitting module.
Fig. 7 is a circuit diagram of the primary unit key module of the present invention when the first signal processing device is the signal transmitting module.
Fig. 8 is a circuit diagram of the primary unit signal transmitting interface of the present invention when the first signal processing device is the signal transmitting module.
Fig. 9 is a circuit diagram of a first part of the primary unit signal transmitting module of the present invention when the first signal processing device is the signal transmitting module.
Fig. 10 is a circuit diagram of the primary unit signal amplifying module of the present invention when the first signal processing device is the signal transmitting module.
Fig. 11 is a circuit diagram of a first part of the primary unit signal feedback module of the present invention when the first signal processing device is the signal transmitting module.
Fig. 12 is a circuit diagram of a second part of the primary unit signal feedback module of the present invention when the first signal processing device is the signal transmitting module.
Fig. 13 is a circuit diagram of a first part of the primary unit electronic control switch of the present invention when the first signal processing device is the signal transmitting module.
Fig. 14 is a circuit diagram of a second part of the primary unit electronic control switch of the present invention when the first signal processing device is the signal transmitting module.
Fig. 15 is a circuit diagram of the secondary unit X-axis secondary amplifying module of the present invention when the first signal processing device is the signal transmitting module.
Fig. 16 is a circuit diagram of the secondary unit Y-axis secondary amplifying module of the present invention when the first signal processing device is the signal transmitting module.
Fig. 17 is a circuit diagram of the secondary unit Z-axis secondary amplifying module of the present invention when the first signal processing device is the signal transmitting module.
Fig. 18 is a circuit diagram of the secondary unit X-axis phase-locked loop module of the present invention when the first signal processing device is the signal transmitting module.
Fig. 19 is a circuit diagram of the secondary unit Y-axis phase-locked loop module of the present invention when the first signal processing device is the signal transmitting module.
Fig. 20 is a circuit diagram of the secondary unit Z-axis phase-locked loop module of the present invention when the first signal processing device is the signal transmitting module.
Fig. 21 is a circuit diagram of the secondary unit wireless voltage signal amplifying module of the present invention when the first signal processing device is the signal transmitting module.
Fig. 22 is a circuit diagram of the secondary unit audio amplifier module of the present invention when the first signal processing device is the signal transmitting module.
Fig. 23 is a circuit diagram of the secondary unit signal receiving connection interface module of the present invention when the first signal processing device is the signal transmitting module.
Fig. 24 is a circuit diagram of the secondary unit central control module of the present invention when the first signal processing device is the signal transmitting module.
Fig. 25 is a circuit diagram of the secondary unit power module of the present invention when the first signal processing device is the signal transmitting module.
Fig. 26 is a circuit diagram of the secondary unit charging module of the present invention when the first signal processing device is the signal transmitting module.
Fig. 27 is a circuit diagram of the secondary unit key module of the present invention when the first signal processing device is the signal transmitting module.
Fig. 28 is a circuit diagram of the secondary unit work indicator module of the present invention when the first signal processing device is the signal transmitting module.
Fig. 29 is a circuit diagram of the secondary unit display module of the present invention when the first signal processing device is the signal transmitting module.
Fig. 30 is a circuit diagram of the secondary unit X-axis primary amplifying module of the present invention when the first signal processing device is the signal transmitting module.
Fig. 31 is a circuit diagram of the secondary unit Y-axis primary amplifying module of the present invention when the first signal processing device is the signal transmitting module.
Fig. 32 is a circuit diagram of the secondary unit Z-axis primary amplifying module of the present invention when the first signal processing device is the signal transmitting module.
Fig. 33 is a circuit diagram of the secondary unit wireless voltage signal receiving module of the present invention when the first signal processing device is the signal transmitting module.
   The following figures are not according to the invention and are present for illustration purposes only.
Fig. 34 is a circuit block diagram of of an illustrative example when the first signal processing device is the signal processing module.
Fig. 35 is a circuit diagram of the primary unit central control module of an illustrative example when the first signal processing device is the signal processing module.
Fig. 36 is a circuit diagram of a first part of the primary unit signal processing module of an illustrative example when the first signal processing device is the signal processing module.
Fig. 37 is a circuit diagram of a second part of the primary unit signal processing module and the signal emitting module of an illustrative example when the first signal processing device is the signal processing module.
Fig. 38 is a circuit diagram of the primary unit USB interface of an illustrative example when the first signal processing device is the signal processing module.
Fig. 39 is a circuit diagram of the primary unit power module of an illustrative example when the first signal processing device is the signal processing module.
Fig. 40 is a circuit diagram of the primary unit switch module of an illustrative example when the first signal processing device is the signal processing module.
Fig. 41 is a circuit diagram of the primary unit power-on indicator module and the voltage detection module of an illustrative example when the first signal processing device is the signal processing module.
Fig. 42 is a circuit diagram of the primary unit voltage regulator module of an illustrative example when the first signal processing device is the signal processing module.
Fig. 43 is a circuit diagram of the secondary unit power switch module of an illustrative example when the first signal processing device is the signal processing module.
Fig. 44 is a circuit diagram of the secondary unit audio amplifier module of an illustrative example when the first signal processing device is the signal processing module.
Fig. 45 is a circuit diagram of the secondary unit filter module of an illustrative example when the first signal processing device is the signal processing module.
Fig. 46 is a circuit diagram of the secondary unit amplifier module of an illustrative example when the first signal processing device is the signal processing module.
Fig. 47 is a circuit diagram of the secondary unit charging management module of an illustrative example when the first signal processing device is the signal processing module.
Fig. 48 is a circuit diagram of the secondary unit boost module of an illustrative example when the first signal processing device is the signal processing module.
Fig. 49 is a schematic diagram of the receiving circuit of an illustrative example determining the cable path when the first signal processing device is the signal processing module.

### Detailed Description of Embodiments

The present embodiment is a preferred embodiment of the disclosure.

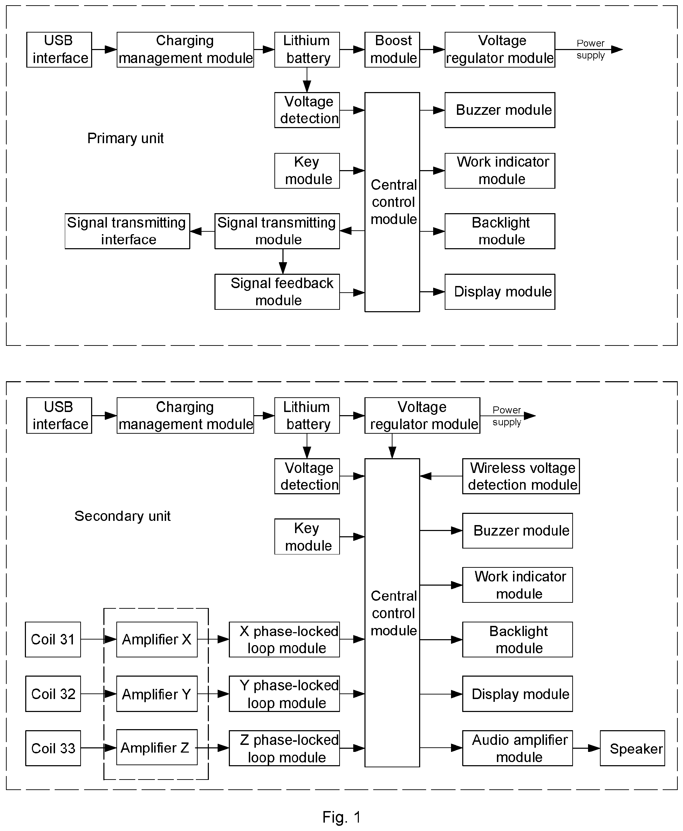

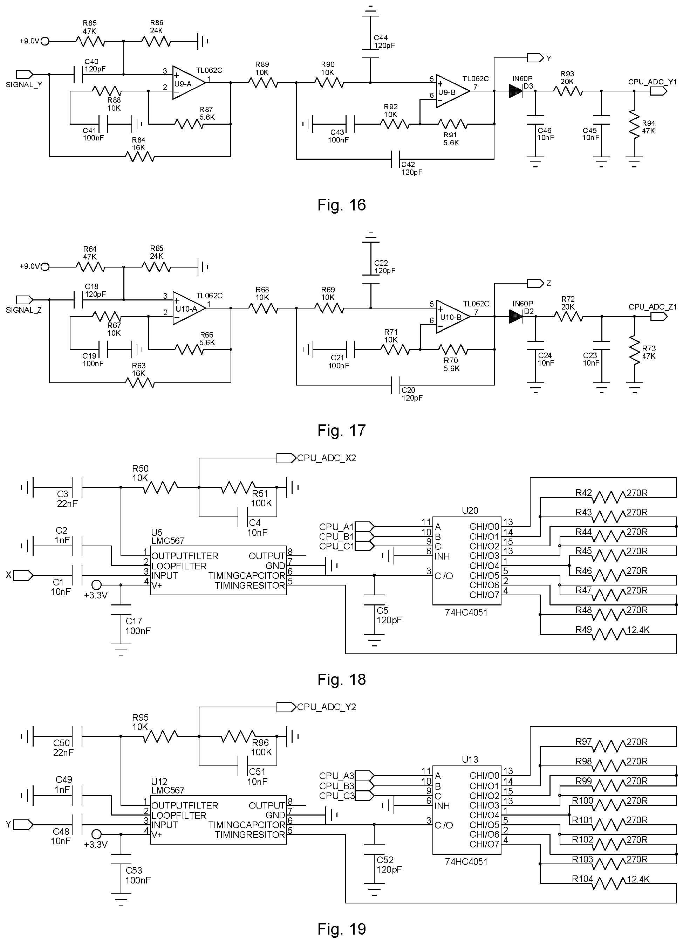

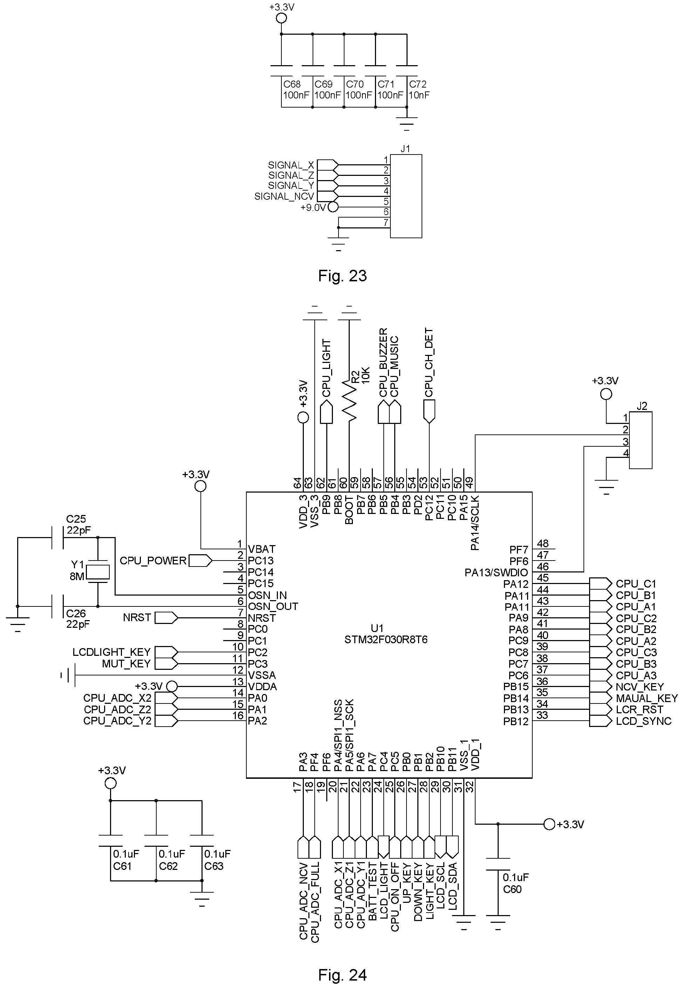

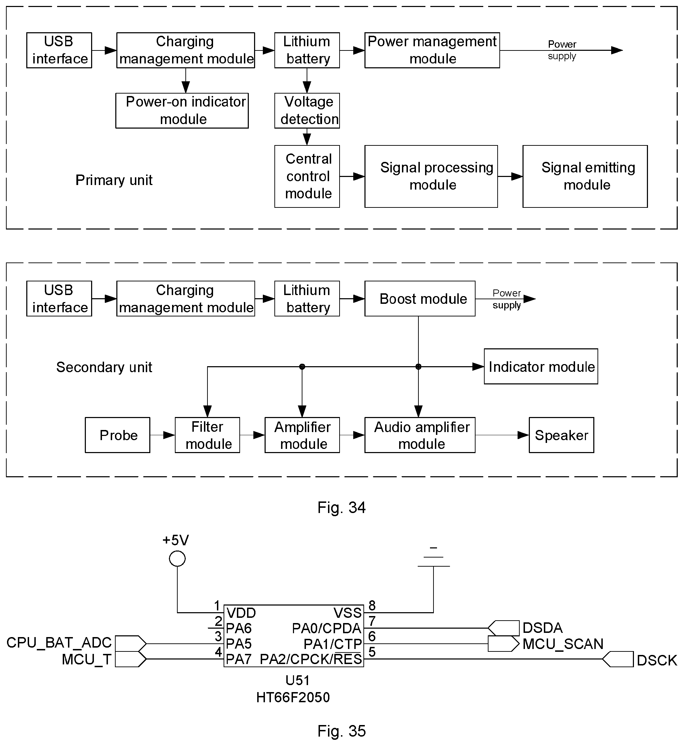

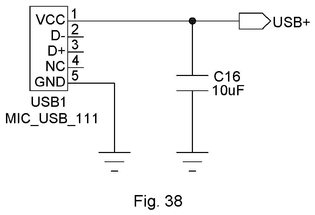

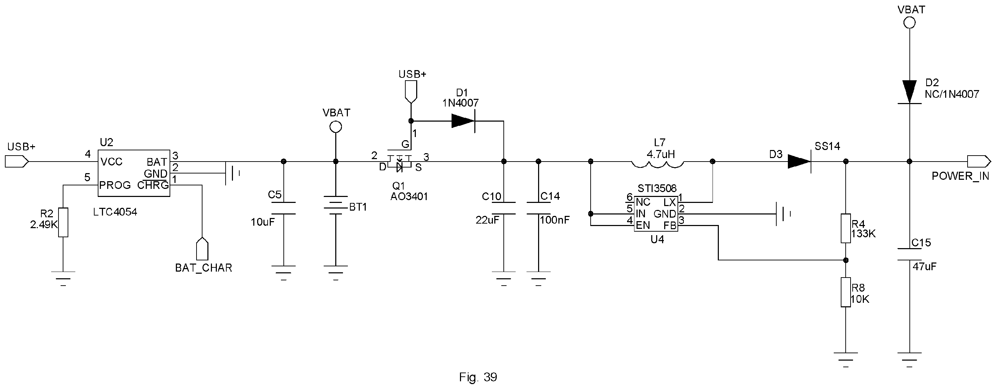

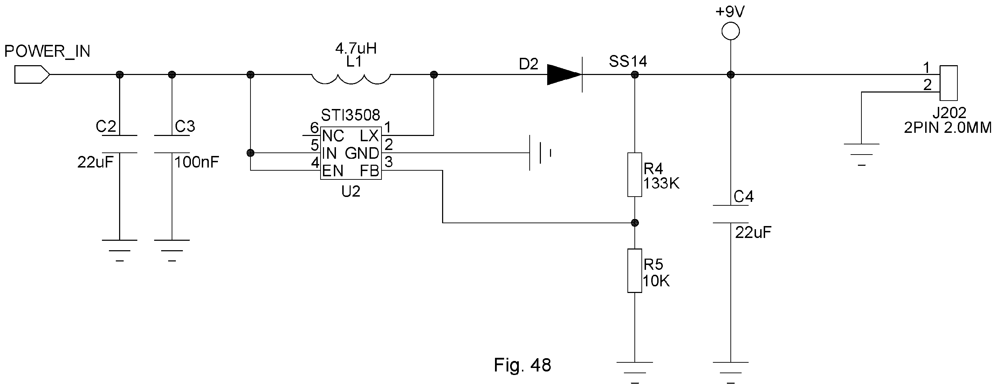

Referring to Figs. 1-49, included in the present disclosure is mainly a primary unit and a secondary unit, in which the primary unit is mainly an emitting circuit, and the secondary unit is, also called as cell phone secondary unit, mainly a receiving circuit.

The primary unit includes a primary unit central control module, a first signal processing device, a second signal processing device, and a primary unit power module, the first signal processing device is connected to a data port of the primary unit central control module, the second signal processing device is connected to an output port of the first signal processing device, the primary unit power module is used to supply power for the primary unit, the second signal processing device is a signal transmitting interface when the first signal processing device is a signal transmitting module, and the second signal processing device is a signal emitting module when the first signal processing device is a signal processing module.

Specifically, the signal transmitting module is connected to a data port of the primary unit central control module, the signal transmitting interface is connected to an output port of the signal transmitting module, the primary unit central control module outputs a clock signal to the signal transmitting module, and the clock signal is processed by the signal transmitting module and transmitted from the signal transmitting interface. The signal processing module is connected to the data port of the central control module, the central control module transmits a PWM wave to the signal processing module, the signal emitting module is connected to the signal processing module, and the PWM wave is amplified by the signal processing module and transmitted from the signal emitting module; the primary unit power module is used to supply power for the primary unit;
the secondary unit includes a secondary unit processing device and a secondary unit power module, the secondary unit processing device includes a first secondary unit processing device or a second secondary unit processing device, the first secondary unit processing device corresponds to the signal transmitting module, and the second secondary unit processing device corresponds to the signal processing module;
the first secondary unit processing device includes a secondary unit central control module, a signal receiving module, a signal amplifying module, and a phase-locked loop module, the signal receiving module is connected to the signal amplifying module, an output port of the signal amplifying module is connected to the phase-locked loop module, and the phase-locked loop module is connected to a data port of the secondary unit central control module;
the second secondary unit processing device includes a probe interface, a filter module, an amplifier module, and an alarm module, the probe interface is connected to an input port of the filter module, an output port of the filter module is connected to an input port of the amplifier module, and the output port of the amplifier module is connected to an input port of the alarm module; and
the signal received by the signal receiving module is transmitted to the signal amplifier module, amplified by the signal amplifier module, transmitted to the phase-locked loop module for processing, processed by the phase-locked loop module and transmitted to the secondary unit central control module, and the secondary unit power module is used to supply power for the secondary unit.

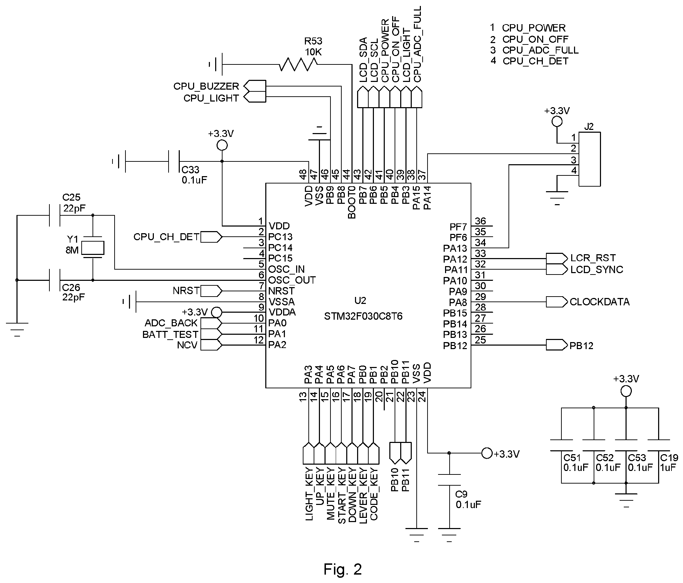

In the present embodiment, referring to Figs. 2, 7, and 35, when the first signal processing device is the signal transmitting module, the primary central control module adopts an MCU chip of model STM32F030C8T6; and when the first signal processing device is the signal processing module, the central control module adopts a small microcontroller U51 of model HT66F2050. For specific implementations, other models of chips may also be used instead. When the first signal processing device is a signal transmitting module, a crystal oscillator module is connected between an OSC_IN interface and an OSC_OUT interface of the primary unit central control module, the crystal oscillator module adopts a quartz crystal oscillator of 8MHz, and the crystal oscillator module is specifically selected according to the primary unit central control module. A power-on reset module is connected to an NRST interface of the primary unit central control module, and the power-on reset module includes capacitor C299 and resistor R355, capacitor C299 is connected between ground and the NRST interface of the central control module, and resistor R355 is connected between the NRST interface of the central control module and a positive power supply (i.e., +3.3V).

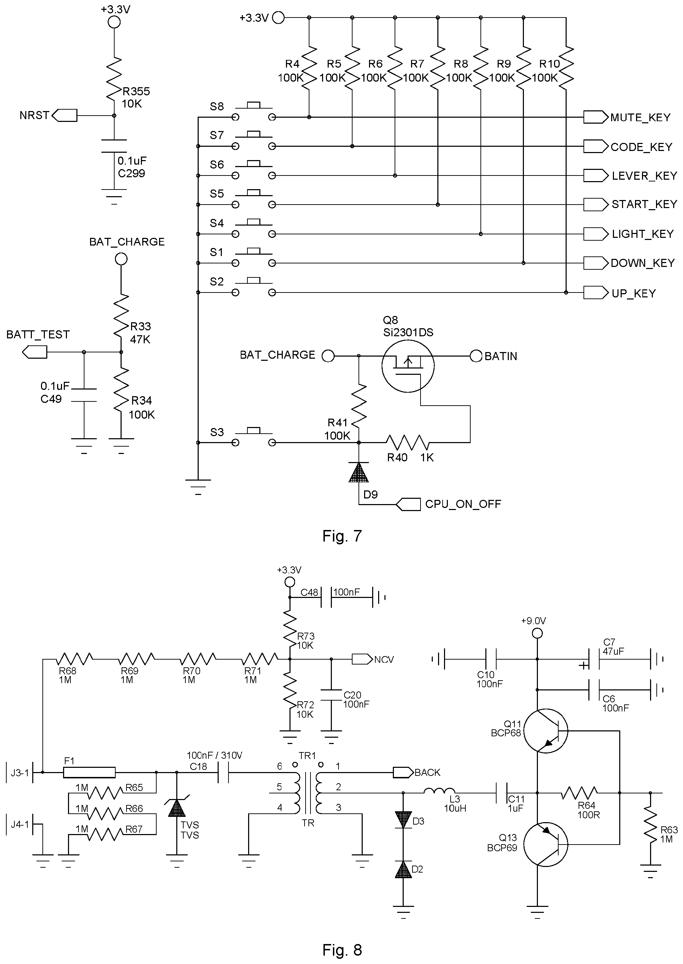

In the present embodiment, referring to Figs. 8-10, when the first signal processing device is the signal transmitting module, the signal transmitting interface adopts an interface J3-1, the first signal processing device includes a dual-D flip-flop U6, an operational amplifier U7, an electronic switch U108, a transistor Q11, a transistor Q13, and an isolation transformer TR1, an interior of the dual-D flip-flop U6 includes a D flip-flop U6-A and a D flip-flop U6-B, an interior of the operational amplifier U7 includes an operational amplifier U7-A and an operational amplifier U7-B, a data port of the central control module is connected to an input port of the D flip-flop U6-B, an output port of the D flip-flop U6-B is connected to an input port of the D flip-flop U6-A, an output port of the D flip-flop U6-A is connected to an input port of the operational amplifier U7-A, an output port of the operational amplifier U7-A is connected to an I/O port B of the electronic switch U108, the I/O port B of the electronic switch U108 is connected to an I/O port A of the electronic switch U108, the I/O port A of the electronic switch U108 is connected to an input port of the operational amplifier U7-B, a 9.0V power supply is connected to ground via a resistor R56 and a resistor R55, a common end between the resistor R56 and the resistor R55 is connected to the I/O port A of the electronic switch U108, a collector of the transistor Q11 is connected to a 9.0V power supply, an emitter of the transistor Q11 is connected to an emitter of the transistor Q13, a collector of the transistor Q13 is grounded, a base of the transistor Q11 is connected to a base of the transistor Q13, an output port of the operational amplifier U7-B is connected to the base of the transistor Q11 and the base of the transistor Q13, the output port of the operational amplifier U7-B is connected to the emitter of the transistor Q11 and the emitter of the transistor Q13 via a resistor R64, the emitter of the transistor Q11 and the emitter of the transistor Q13 are connected to a primary coil of the isolation transformer TR1 through a capacitor C11 and an inductor L3 connected in series, and the secondary coil of the isolation transformer TR1 is connected to an interface J3-1. The clock signal from the central control module is transmitted to the input port of the D flip-flop U6-B, frequency adjusted by the dual-D flip-flop U6, and then input to the operational amplifier U7 for amplifying the signal. The central control module controls the amplitude and timing of the output signal by controlling the dual-D flip-flop U6 and the operational amplifier U7, the push-pull circuit by connecting the transistor Q11 and the transistor Q13 improves load capacity and stabilizes output, so as to be isolated from the electrified cable via the isolation transformer TR1 and transmit the output signal to the output probe, and a final emitted signal is formed with positive and negative polarities, with adjustable timing, and with adjustable amplitude.

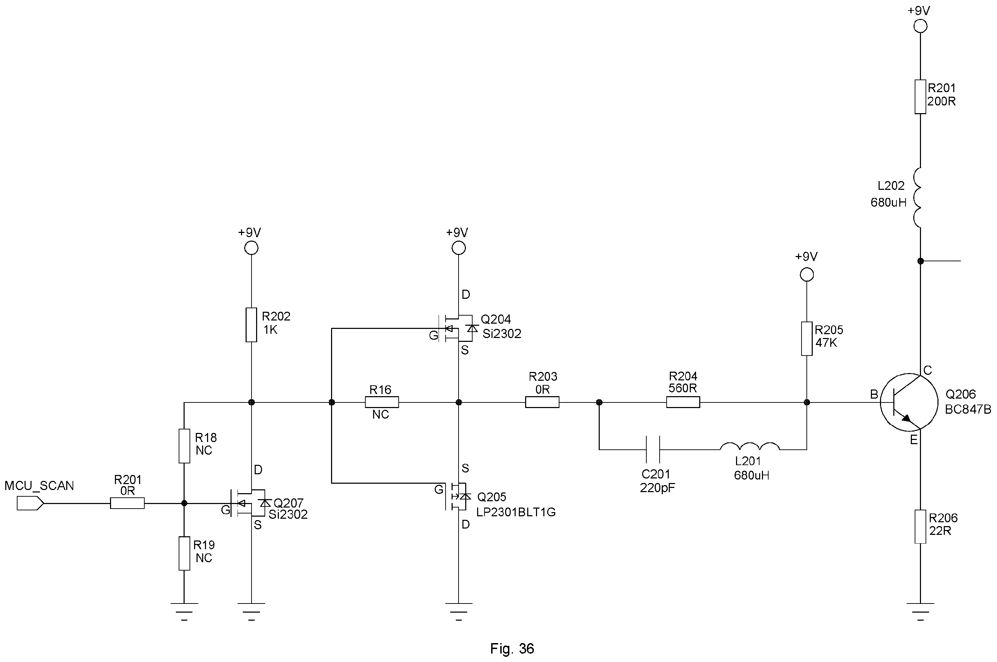

The following embodiment is not according to the invention and is present for illustration purposes only. Referring to Figs. 36-37, when the first signal processing device is the signal processing module, the signal processing module includes an MOS transistor Q207, an MOS transistor Q204, an MOS transistor Q205, a transistor Q206 and a transistor Q203, a gate of the MOS transistor Q207 is a signal input port of the signal processing module, the gate of the MOS transistor Q207 is connected to a data port of the central control module via a resistor R201, a source of the MOS transistor Q207 is grounded, a drain of the MOS transistor Q207 is connected to a +9V power supply via a resistor R202, gates of the MOS transistor Q204 and the MOS transistor Q205 are connected to the drain of the MOS transistor Q207 respectively, a drain of the MOS transistor Q204 is connected to a +9V power supply, a drain of the MOS transistor Q205 is grounded, a source of the MOS transistor Q204 is connected to a source of the MOS transistor Q205, the source of the MOS transistor Q204 is connected to a base of the transistor Q206 via a resistor R203 and a resistor R204 connected in series, a capacitor C201 and an inductor L201 are connected in series, the capacitor C201 and the inductor L201 connected in series are connected to a resistor R204 in parallel, a base of the transistor Q206 is connected to a +9V power supply via a resistor R205, an emitter of the transistor Q206 is grounded via a resistor R206, a collector of the transistor Q206 is connected to a +9V power supply via a resistor R201 and an inductor L202 connected in series, the collector of the transistor Q206 is connected to a base of the transistor Q203 via a capacitor C202 and an inductor L203 connected in series, an emitter of the transistor Q203 is grounded via a variable resistor VR1, a center tap of the variable resistor VR1 is grounded via a resistor R208, a collector of the transistor Q203 is connected to a +9V power supply via an inductor L204, a base of the transistor Q203 is connected to the signal emitting module via a resistor R208, an inductor L205, a capacitor C203, and a thermistor PTC1 sequentially connected in series, a common end between the resistor R208 and the inductor L205 is connected to the collector of the transistor Q203, and a common end between the capacitor C203 and the thermistor PTC1 is grounded via a capacitor C204 and an inductor L206 connected in series. In the present embodiment, the signal emitting module adopts an interface for connecting an emitting probe to detect the emission of signal.

Referring to Fig. 36, the emitting circuit emits a PWM wave with a certain frequency to match the receiving circuit. Only stable signal output may be used to perform a better detection for the path and depth of the cables, which requires an LC frequency selection network of the emitted signal provides a reliable property of frequency selection, and the selected parameter may not be too large or too small. The frequency selection calculation formula: $f = \frac{1}{2 π \sqrt{L \times C}}$, in which L is the inductance value of the LC frequency selection network and C is the capacitance value of the LC frequency selection network. In the present embodiment, the capacitor C201 and the inductor L201 connected in series form a first LC frequency selection network, and the capacitor C202 and the inductor L203 connected in series form a second LC frequency selection network.

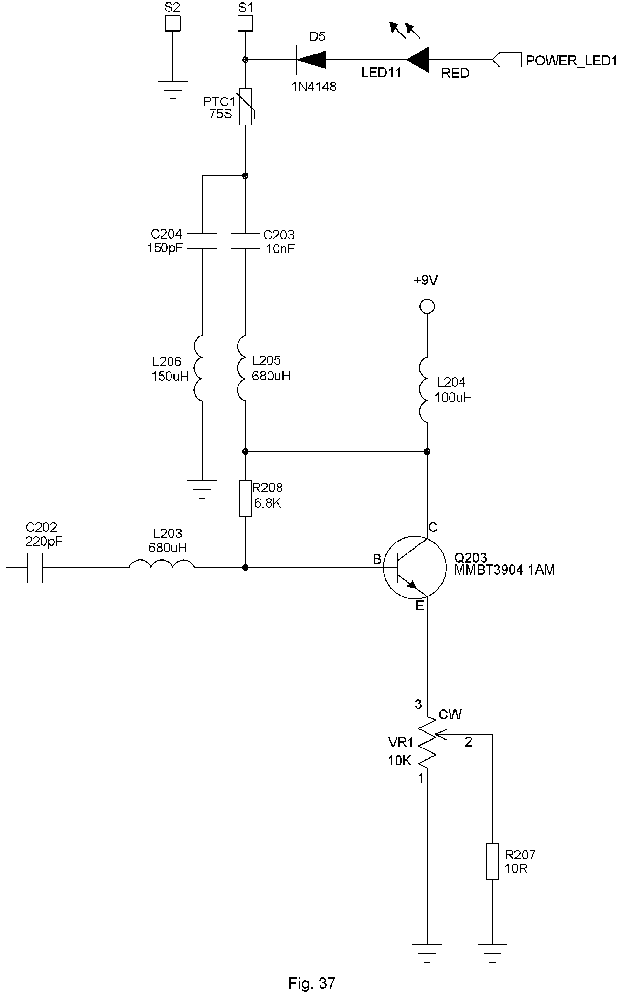

Referring to Fig. 37, the variable resistor VR1 is used to regulate the strength of the emitted signal. The resistor R207 restricts a maximum current in the circuit which serves to protect the transistor Q203. However, the value of the resistor R207 should not be too large, as it renders the amplitude of the emitted signal to be smaller at maximum, which results in the signal not being captured by the receiver probe, reducing the maximum distance of detecting the cable path.

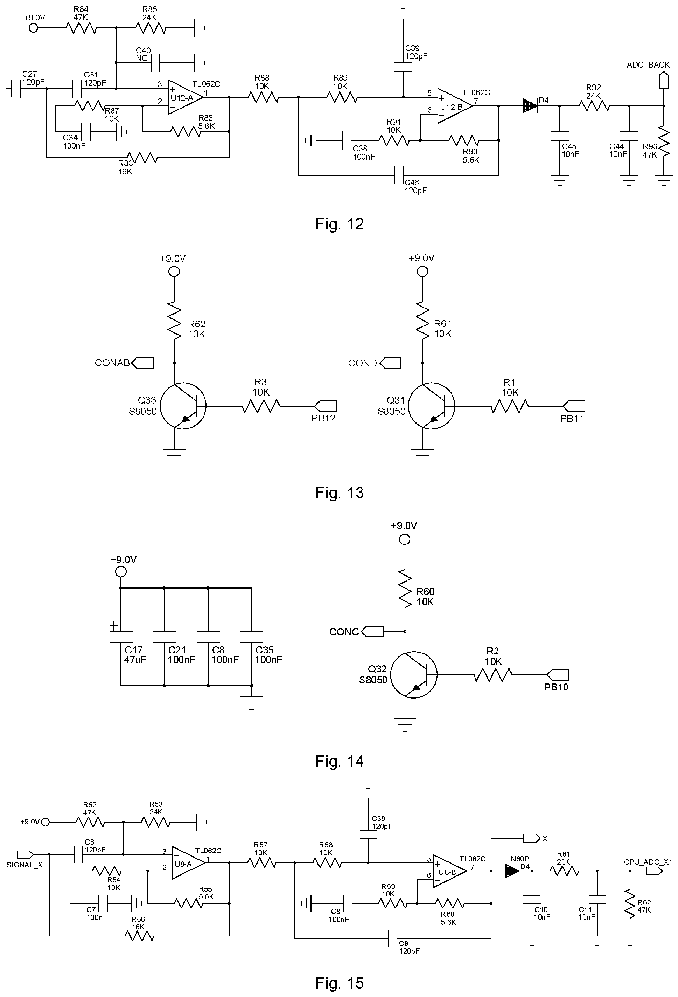

In the present embodiment, referring to Figs. 13-14, when the first signal processing device is a signal transmitting module, a data port of the central control module is connected with a primary unit electronic control switch, the primary unit electronic control switch includes a transistor Q31, a transistor Q32, and a transistor Q33, bases of the transistor Q31, the transistor Q32, and the transistor Q33 are connected to data ports of the primary unit central control module respectively, emitters of the transistor Q31, the transistor Q32, and the transistor Q33 are grounded respectively, and collectors of the transistor Q31, the transistor Q32, and the transistor Q33 are connected control ports of an electronic switch U 108 respectively. The central control module controls the on and off of the channels of the electronic switch U108 by means of the transistor Q31, the transistor Q32 and the transistor Q33, so as to achieve control of the timing of the output signals.

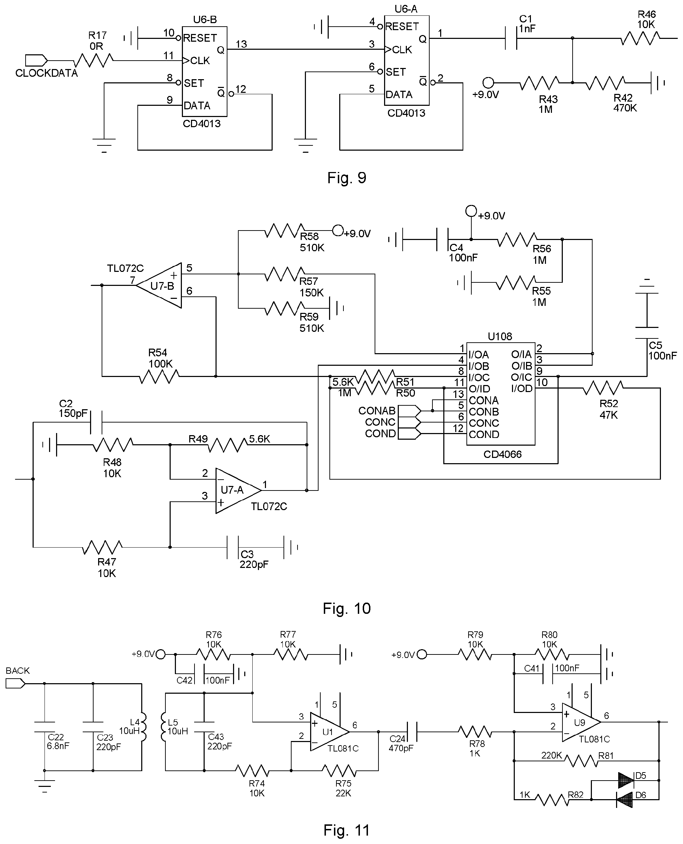

In the present embodiment, referring to Figs. 11-12, when the first signal processing device is the signal transmitting module, the primary unit part further includes a signal feedback module, the signal feedback module includes an operational amplifier U1, an operational amplifier U9, an operational amplifier U12-A, and an operational amplifier U12-B, the operational amplifier U1, operational amplifier U9, operational amplifier U12-A, and operational amplifier U12-B are connected in sequence to form a four-stage amplification system, a signal input port of the signal feedback module is connected to a primary coil of an isolation transformer TR1, and an output port of the signal feedback module is connected to a data port of the central control module.

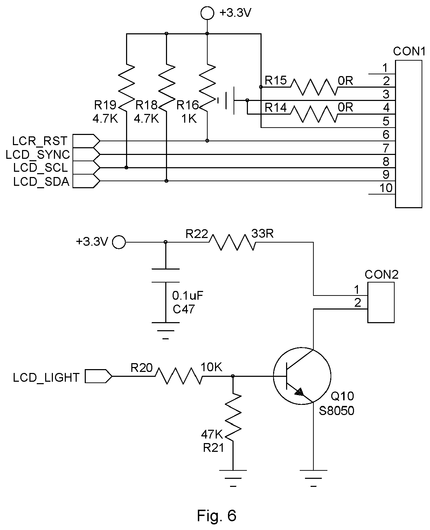

In the present embodiment, referring to Fig. 6, when the first signal processing device is the signal transmitting module, the data port of the primary unit central control module is connected with a primary unit display module, and the primary unit display module adopts an LCD interface CON1 for connecting a LCD display screen to display the detection data.

In the present embodiment, referring to Fig. 6, when the first signal processing device is the signal transmitting module, a primary unit backlight module is connected to the data port of the primary unit central control module, the primary unit backlight module includes a current limiting resistor R22, an electronic control switch Q10, and a backlight interface CON2 used to connect the backlight LED, the current limiting resistor R22, the backlight interface CON2, and the electronic control switch Q10 are sequentially connected in series between a positive power supply (i.e., +3.3V) and ground, and a control port of the electronic control switch Q10 is connected to a data port of the primary unit central control module. The primary unit central control module controls the on and off of the electronic control switch Q10, so as to control the operation of the backlight. In the present embodiment, the electronic control switch Q10 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the primary unit central control module via a current limiting resistor R20.

In the present embodiment, referring to Fig. 7, when the first signal processing device is the signal transmitting module, a primary unit key module is connected to the data port of the primary unit central control module, in which the primary unit key module includes a key switch S1, a key switch S2, a key switch S3, a key switch S4, a key switch S5, a key switch S6, a key switch S7, and a key switch S8, and the key switch S1, the key switch S2, the key switch S3, the key switch S4, the key switch S5, the key switch S6, the key switch S7, and the key switch S8 are connected between the data port of the primary unit central control module and ground, respectively.

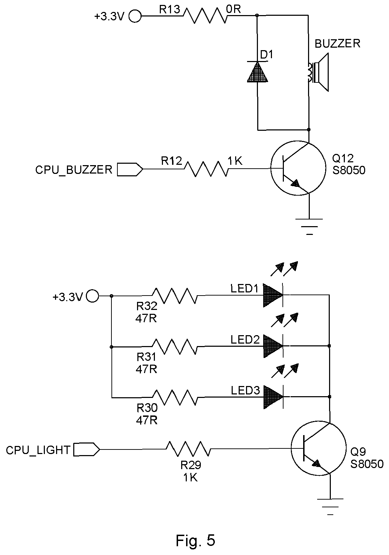

In the present embodiment, referring to Fig. 5, when the first signal processing device is the signal transmitting module, a buzzer module is connected to the data port of the primary unit central control module, in which the buzzer module includes a buzzer and an electronic control switch Q12, the buzzer and the electronic control switch Q12 are connected in series between the positive power supply (i.e., +3.3V) and ground, and a control port of the electronic control switch Q12 is connected to a data port of the primary unit central control module. The primary unit central control module controls the on and off of the electronic control switch Q12, so as to control the operation of the buzzer. In the present embodiment, the electronic control switch Q12 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the primary unit central control module via a current limiting resistor R12.

In the present embodiment, referring to Fig. 5, when the first signal processing device is the signal transmitting module, a work indicator module is connected to the data port of the primary unit central control module, in which the work indicator module includes a current limiting resistor R30, a current limiting resistor R31, a current limiting resistor R32, an electronic control switch Q9, an indicator LED1, an indicator LED2, and an indicator LED3, the current limiting resistor R32 and the indicator LED1 are connected in series, the current limiting resistor R31 and the indicator LED2 are connected in series, the current limiting resistor R30 and the indicator LED3 are connected in series, the series-connected current limiting resistor R32 and the indicator LED1, the series-connected current limiting resistor R31 and the indicator LED2, and the series-connected current limiting resistor R30 and the indicator LED3 are connected in parallel and are connected between the positive power supply (i.e., +3.3V) and ground via the electronic control switch Q9, and a control port of the electronic control switch Q9 is connected to a data port of the primary unit central control module. The primary unit central control module controls the on and off of the electronic control switch Q9, so as to control the operation of the indicator LED1, the indicator LED2, and the indicator LED3. In the present embodiment, the electronic control switch Q9 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the primary unit central control module via a current limiting resistor R29.

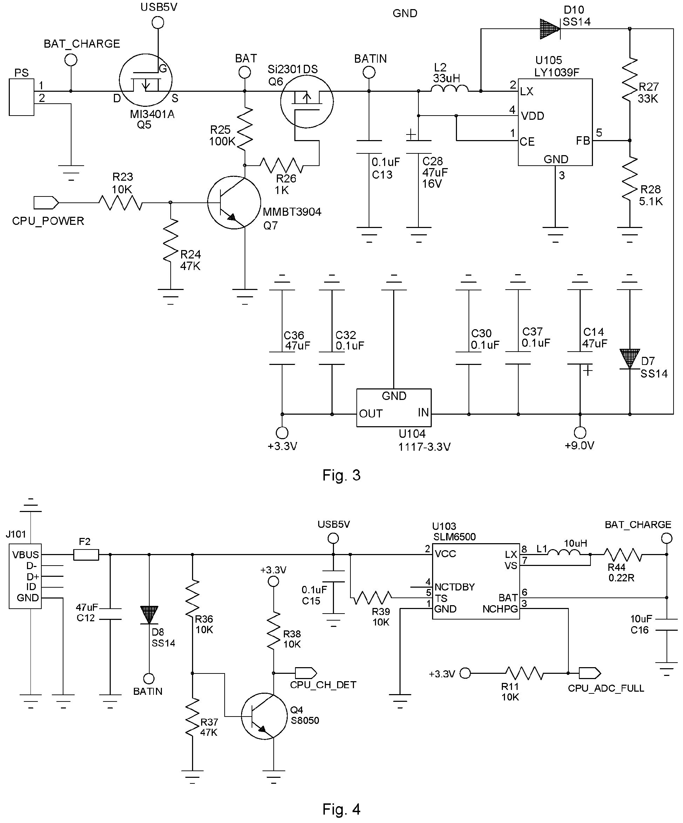

In the present embodiment, referring to Fig. 4, the primary unit power module includes a primary unit USB interface (this interface is denoted by J101 when the first signal processing device is the signal transmitting module), a primary unit charging management module (this module is denoted by U103 when the first signal processing device is the signal transmitting module), a primary unit lithium battery, and a primary unit power management device, the primary unit USB interface is connected to a power input port of the primary unit charging management module, the primary unit lithium battery is connected to a power output port of the primary unit charging management module, and the primary unit lithium battery is charged via the primary unit USB interface.

Referring to Figs. 3-4, when the first signal processing device is a signal transmitting module, the primary unit power management device includes a primary unit boost chip U105 and a primary unit voltage regulator chip U104, the primary unit USB interface J101 is connected to a power input port of the primary unit charging management module U103, the primary unit lithium battery is connected to a power output port of the primary unit charging management module U103, the primary unit lithium battery is charged via the primary unit USB interface J101, a power input port of the primary unit boost chip U105 is connected to the primary unit lithium battery, a voltage of the primary unit lithium battery is converted to +9.0V for power supply via the primary unit boost chip U105, and +9.0V voltage is regulated to +3.3V via the primary unit voltage regulator chip U104 and then output to the primary unit for power supply.

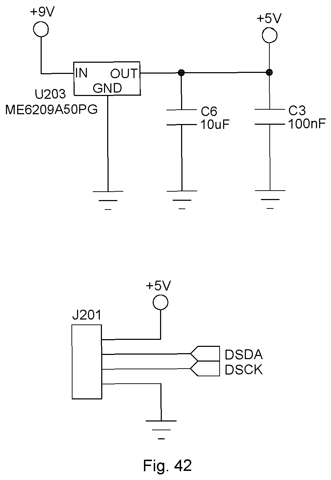

Referring to Fig. 42, when the first signal processing device is the signal processing module, the primary unit power management device includes a primary unit power management module and a voltage regulator module, the primary unit USB interface is connected to a power input port of the primary unit charging management module, the primary unit lithium battery is connected to a power output port of the primary unit charging management module, the primary unit USB interface is used to input power, the input power charges the primary unit lithium battery via the primary unit charging management module, a power input port of a primary unit power management module is connected to the primary unit lithium battery, the output power of the primary unit lithium battery is converted to +9V for supplying power by the primary unit power management module. In the present embodiment, the voltage regulator module adopts a voltage regulator chip U203 of model ME6209A50PG, which converts the power from +9V to +5V to supply power for the central control module.

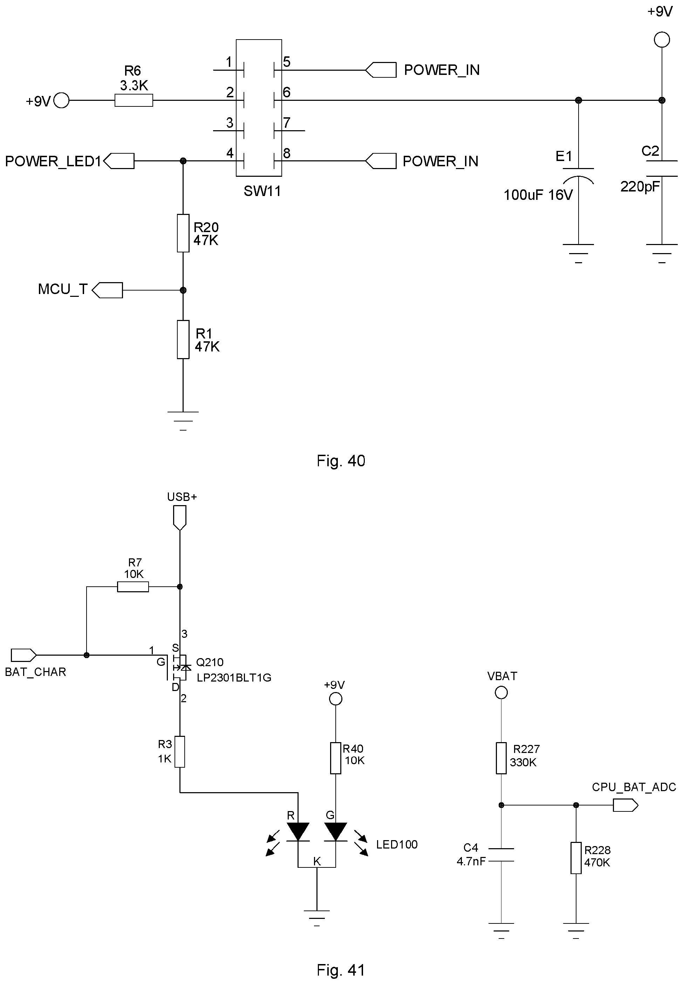

In the present embodiment, referring to Figs. 7 and 41 a positive electrode of the primary unit lithium battery is connected with a primary unit battery voltage detection module for detecting the voltage of the lithium battery, the primary unit battery voltage detection module includes two resistors connected in series, and a common end between two resistors is connected to a data port of the primary unit central control module; and when the first signal processing device is the signal transmitting module, a positive electrode of the secondary unit lithium battery is connected with a secondary unit battery voltage detection module, the secondary unit battery voltage detection module includes two resistors connected in series, and a common end between two resistors is connected to a data port of the secondary unit central control module. Specifically, when the first signal processing device is the signal transmitting module, the primary unit battery voltage detection module includes a resistor R33 and a resistor R34 connected in series, a common end between the resistor R33 and the resistor R34 is connected to a data port of the primary unit central control module; and when the first signal processing device is the signal processing module, the primary unit battery voltage detection module includes a resistor R227 and a resistor R228, the resistor R227 and the resistor R228 are connected in series between the positive electrode of the primary unit lithium battery and ground, a common end between the resistor R227 and the resistor R228 is connected to a data port of the primary unit central control module, and this data port has an ADC function.

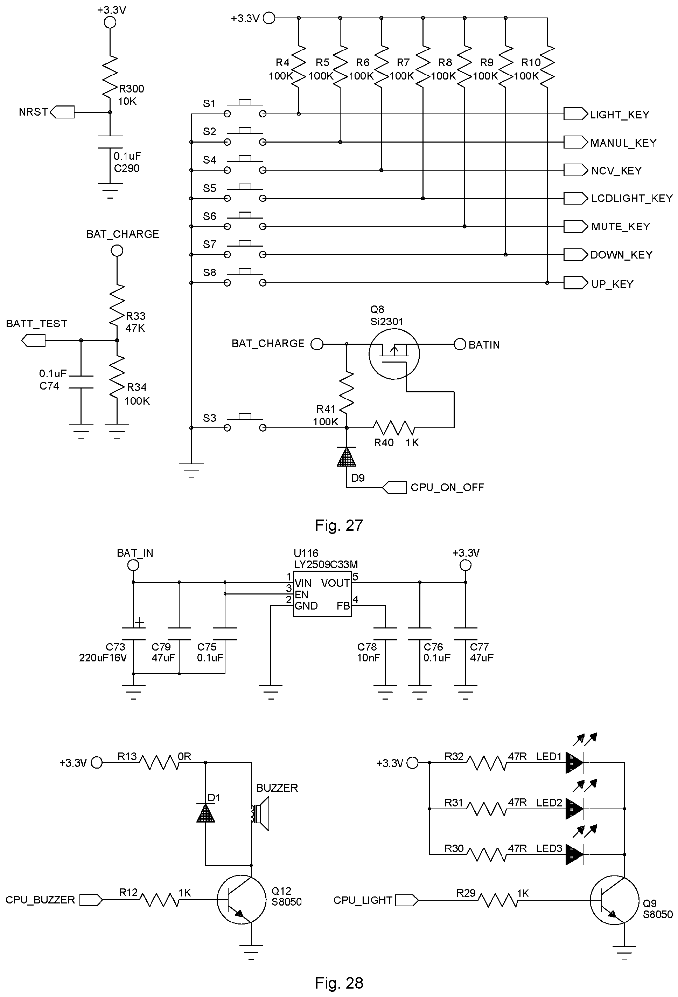

In the present embodiment, referring to Figs. 27, when the first signal processing device is the signal transmitting module, the secondary unit central control module adopts an MCU chip of model STM32F030C8T6. For specific implementation, other types of chips may also be used instead. A crystal oscillator module is connected between an OSC_IN interface and an OSC_OUT interface of the secondary unit central control module, in which the crystal oscillator module adopts a quartz crystal oscillator of 8MHz, and the crystal oscillator module is specifically selected according to the secondary unit central control module. A power-on reset module is connected to an NRST interface of the secondary unit central control module, and the power-on reset module includes capacitor C290 and resistor R300, capacitor C290 is connected between ground and the NRST interface of the central control module, and resistor R300 is connected between the NRST interface of the central control module and a positive power supply (i.e., +3.3V).

Since the emitted signal has positive and negative polarities, the electromagnetic field generated by the conductor connected to the emitting probe also has directions. The receiving circuit of the present disclosure processes the received signals from three stereoscopic directions: X-axis, Y-axis and Z-axis, which fully improves the efficiency and reliability of the testing. Due to the high specificity of the emitted signal, the microcontroller digital signal processing circuit determines and distinguishes the signal received by the receiving circuit. Only when receiving a timing signal as same as the emitted signal, the receiving circuit performs a feedback, which greatly improves the accuracy of the inspection and eliminates false tests. In the present embodiment, the receiving circuits of X-axis, Y-axis and Z-axis are the same, and the X-axis is taken as an example to be described in detail as follow.

Referring to Figs. 15, 18, and 30, the receiving coil L31 is connected to an input port of the X-axis primary amplifying module, the X-axis primary amplifying module includes an operational amplifier U1-A and an operational amplifier U1-B, the operational amplifier U1-A and the operational amplifier U1-B are connected to form a two-stage amplification circuit to perform a primary amplification of the signal received by the receiving coil L31, the X-axis primary amplifying module is connected to the X-axis secondary amplifying module via an interface J1, the X-axis secondary amplifying module includes an operational amplifier U8-A and an operational amplifier U8-B, the operational amplifier U8-A and the operational amplifier U8-B are connected to form a two-stage amplification circuit to perform a further amplification of the signal received by the receiving coil L31, one branch of an output port of the X-axis secondary amplifying module is connected to a data port of the secondary unit central control module, another branch of the output port of the X-axis secondary amplifying module is connected to an input port of the X-axis phase-locked loop module, an output port of the X-axis phase-locked loop module is connected to a data port of the secondary unit central control module, a clock signal port of the X-axis phase-locked loop module is connected to a channel selector U20, and a control port of the channel selector U20 is connected to a data port of the secondary unit central control module.

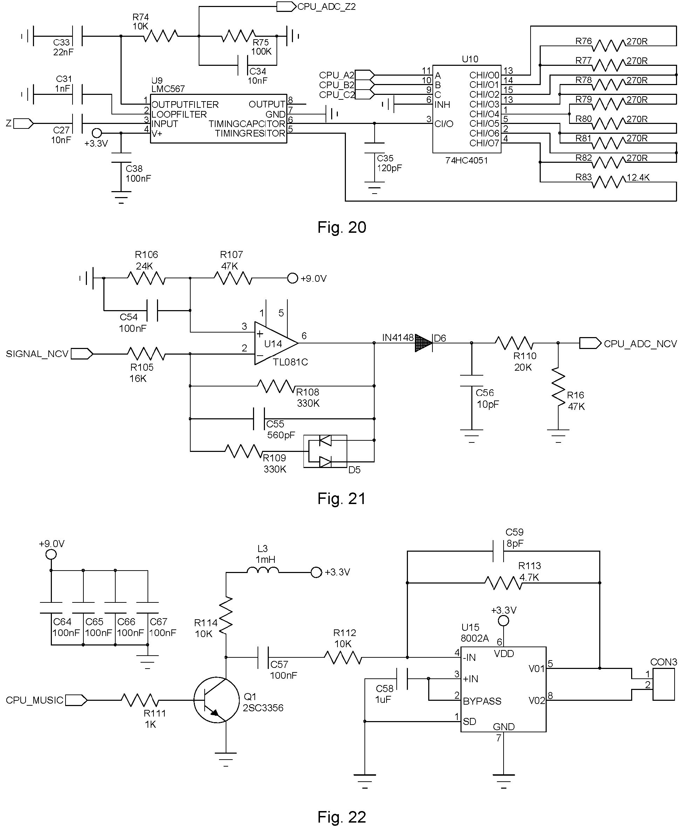

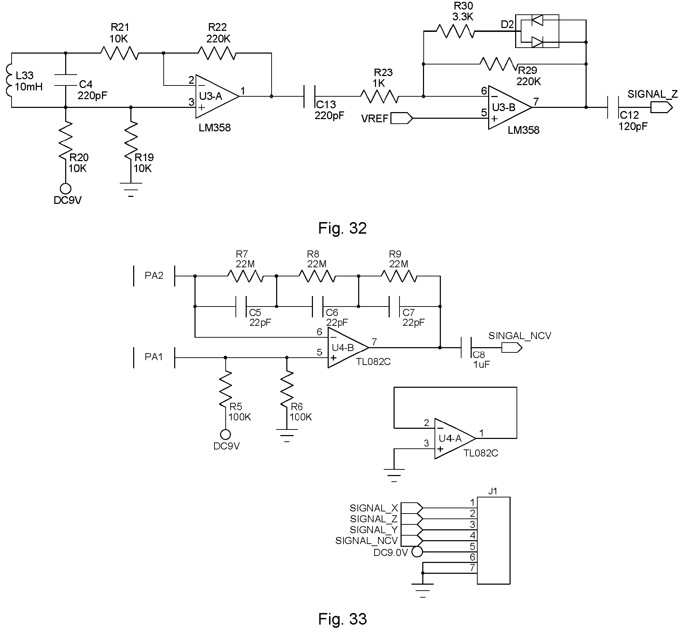

In the present embodiment, referring to Figs. 21 and 33, when the first signal processing device is the signal transmitting module, the secondary unit further includes a wireless voltage detection module, the wireless voltage detection module includes a non-contact voltage detection coil, an operational amplifier U4-B, and an operational amplifier U14, the non-contact voltage detection coil is connected to an input port of the operational amplifier U4-B, an output of the operational amplifier U4-B is connected to an input port of the operational amplifier U14, and an output port of the operational amplifier U14 is connected to a data port of the secondary unit central control module, so as to perform a non-contact voltage detection.

In the present embodiment, referring to Fig. 22, when the first signal processing device is the signal transmitting module, a data port of the secondary unit central control module is connected with an audio amplifier chip U15, and an output port of the audio amplifier chip U15 is connected with a speaker.

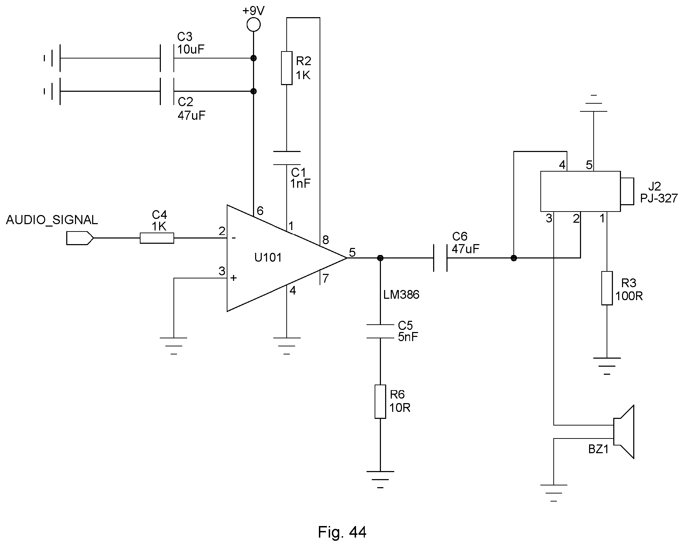

The following embodiment is not according to the invention and is present for illustration purposes only. Referring to Fig. 44, when the first signal processing device is the signal processing module, the alarm module includes an audio power amplifier U101 and a speaker BZ1, an output port of the amplifier module is connected to a signal input port of the audio power amplifier U101, and an output port of the audio power amplifier U101 is connected to the speaker BZ1.

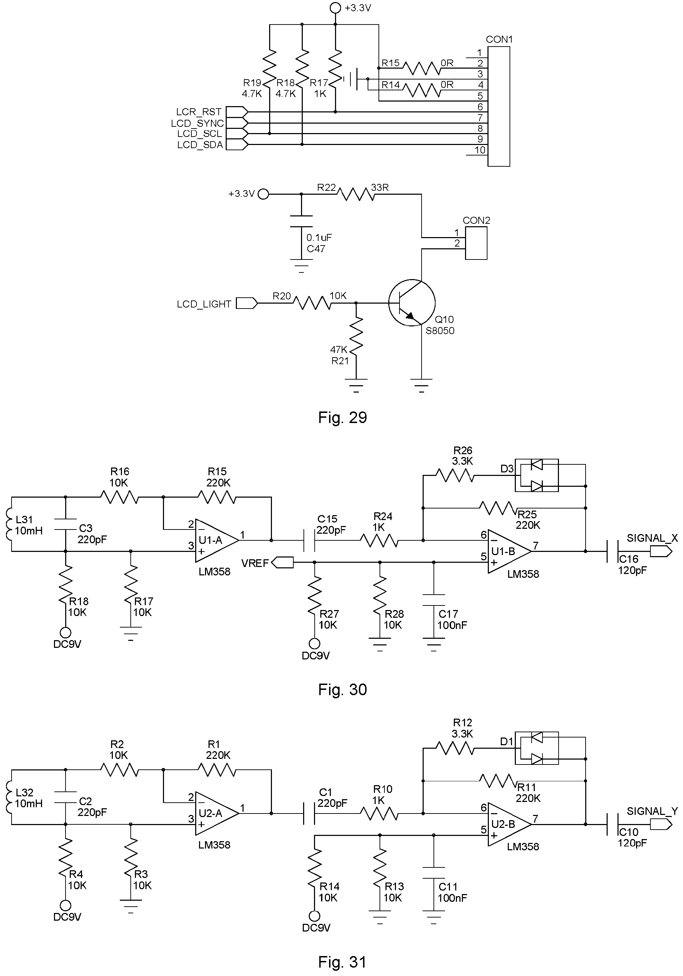

In the present embodiment, referring to Fig. 29, a secondary unit display module is connected to the data port of the secondary unit central control module, in which the electronic components contained in the secondary unit display module and the connection relationship between them are the same as those contained in the primary unit display module and the connection relationship between them. That is, the secondary unit display module also adopts the LCD interface CON1 for connecting the LCD display screen to display the detection data.

In the present embodiment, referring to Fig. 29, a secondary unit backlight module is connected to the data port of the secondary unit central control module, in which the electronic components contained in the secondary unit backlight module and the connection relationship between them are the same as those contained in the primary unit backlight module and the connection relationship between them. That is, the secondary unit backlight module also includes a current limiting resistor R22, an electronic control switch Q10, and a backlight interface CON2 used to connect the backlight LED, the current limiting resistor R22, the backlight interface CON2, and the electronic control switch Q10 are sequentially connected in series between a positive power supply (i.e., +3.3V) and ground, and a control port of the electronic control switch Q10 is connected to a data port of the secondary unit central control module. The secondary unit central control module controls the on and off of the electronic control switch Q10, so as to control the operation of the backlight. In the present embodiment, the electronic control switch Q10 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the central control module via a current limiting resistor R20.

In the present embodiment, referring to Fig. 27, the data port of the secondary unit central control module is connected with a secondary unit key module, in which the electronic components contained in the secondary unit key module and the connection relationship between them are the same as those contained in the primary unit key module and the connection relationship between them. The secondary unit key module includes a key switch S1, a key switch S2, a key switch S3, a key switch S4, a key switch S5, a key switch S6, a key switch S7, and a key switch S8, and the key switch S1, the key switch S2, the key switch S3, the key switch S4, the key switch S5, the key switch S6, the key switch S7, and the key switch S8 are connected between the data port of the secondary unit central control module and ground, respectively.

In the present embodiment, referring to Fig. 28, the data port of the secondary unit central control module is connected with a secondary unit buzzer module, in which the electronic components contained in the secondary unit buzzer module and the connection relationship between them are the same as those contained in the primary unit buzzer module and the connection relationship between them. That is, the secondary unit buzzer module also includes a buzzer and an electronic control switch Q12, the buzzer and the electronic control switch Q12 are connected in series between the positive power supply (i.e., 3.3V) and ground, and a control port of the electronic control switch Q12 is connected to a data port of the secondary unit central control module. The secondary unit central control module controls the on and off of the electronic control switch Q12, so as to control the operation of the buzzer. In the present embodiment, the electronic control switch Q12 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the secondary unit central control module via a current limiting resistor R12.

In the present embodiment, referring to Fig. 28, the data port of the secondary unit central control module is connected with a secondary unit work indicator module, in which the electronic components contained in the secondary unit work indicator module and the connection relationship between them are the same as those contained in the primary unit work indicator module and the connection relationship between them. The secondary unit work indicator module also includes a current limiting resistor R30, a current limiting resistor R31, a current limiting resistor R32, an electronic control switch Q9, an indicator LED1, an indicator LED2, and an indicator LED3, the current limiting resistor R32 and the indicator LED1 are connected in series, the current limiting resistor R31 and the indicator LED2 are connected in series, the current limiting resistor R30 and the indicator LED3 are connected in series, the series-connected current limiting resistor R32 and the indicator LED1, the series-connected current limiting resistor R31 and the indicator LED2, and the series-connected current limiting resistor R30 and the indicator LED3 are connected in parallel and are connected between the positive power supply (i.e., +3.3V) and ground via the electronic control switch Q9, and a control port of the electronic control switch Q9 is connected to a data port of the secondary unit central control module. The secondary unit central control module controls the on and off of the electronic control switch Q9, so as to control the operation of the indicator LED1, the indicator LED2, and the indicator LED3. In the present embodiment, the electronic control switch Q9 may adopt such as a PNP type transistor, a NPN type transistor, a field-effect transistor, controllable silicon, or other components that are able to control its on and off by electronic means. In the present embodiment, a transistor is taken as an example, a base of the transistor is connected to the data port of the secondary unit central control module via a current limiting resistor R29.

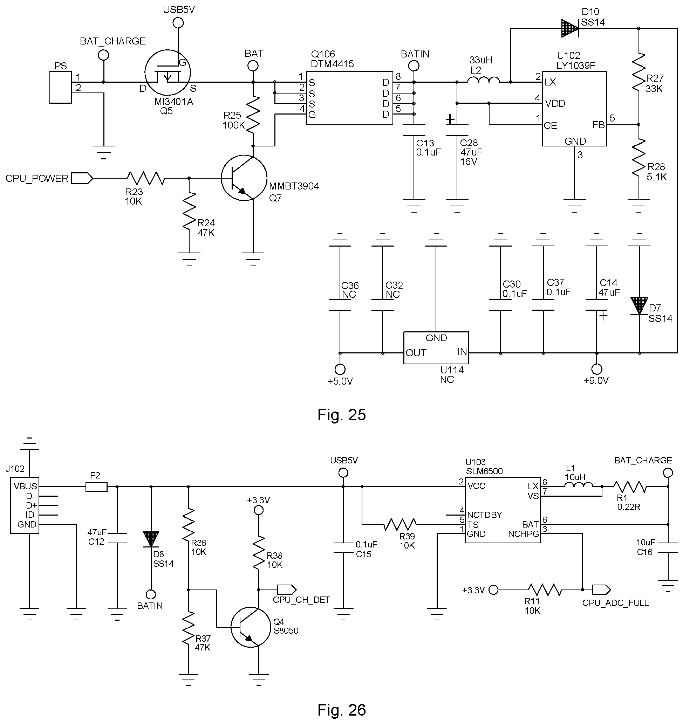

In the present embodiment, referring to Fig. 26, the secondary unit power module includes a secondary unit USB interface (this interface is denoted by J102 when the first signal processing device is the signal transmitting module), a secondary unit charging management module (this module is denoted by U103 when the first signal processing device is the signal transmitting module), a secondary unit lithium battery, and a secondary unit power management device, the secondary unit USB interface is connected to a power input port of the secondary unit charging management module, the secondary unit lithium battery is connected to a power output port of the secondary unit charging management module, and the secondary unit lithium battery is charged via the secondary unit USB interface.

Referring to Fig. 25, when the first signal processing device is a signal transmitting module, the secondary unit power management device includes an MOSFET chip Q106, a secondary unit boost chip U102, a first secondary unit voltage regulator chip U114, and a second secondary unit voltage regulator chip U116, a power input port of the secondary unit boost chip U102 is connected to the secondary unit lithium battery via the MOSFET chip Q106, a voltage of the secondary unit lithium battery is converted to +9.0V for power supply via the secondary unit boost chip U102, +9.0V voltage is regulated to +5.0V via the first secondary unit voltage regulator chip U114 and then output to the secondary unit for power supply, and a voltage of the secondary unit lithium battery is regulated to +3.3V via the second secondary unit voltage regulator chip U116 and then output to the secondary unit for power supply.

The following embodiment is not according to the invention and are present for illustration purposes only. When the first signal processing device is the signal processing module, the secondary unit power management device includes a secondary unit power management module, the secondary unit USB interface is connected to a power input port of the secondary unit charging management module, the secondary unit lithium battery is connected to a power output port of the secondary unit charging management module, the secondary unit USB interface is used to input power, the input power charges the secondary unit lithium battery via the secondary unit charging management module, a power input port of a secondary unit power management module is connected to the secondary unit lithium battery, the output power of the secondary unit lithium battery is converted to +9V for supplying power by the secondary unit power management module.

In the present embodiment, referring to Fig. 27, when the first signal processing device is the signal transmitting module, a positive electrode of the secondary unit lithium battery is connected with a secondary unit battery voltage detection module for detecting the voltage of the lithium battery, the secondary unit battery voltage detection module includes a resistor R33 and a resistor R34 connected in series, and a common end between the resistor R33 and the resistor R34 is connected to a data port of the secondary unit central control module.

When in use, the emitting circuit of the present disclosure adopts a set output frequency 125KHz. The timing and size of the output signal is controlled by the electronic switch U108, which is isolated from the power grid by isolation transformer TR1 to achieve the purpose of test that is able to be connected to electrified cables. Different arrangements of receiving coil L31, receiving coil L32, and receiving coil L33 in the space position achieve a full range of signal detection in the X-axis, Y-axis, and Z-axis directions, and the receiving circuit collects, amplifies, and modulates the signal in all directions from the X-axis, Y-axis, and Z-axis directions.

The following embodiments are not according to the invention and are present for illustration purposes only. Referring to Fig. 41, when the first signal processing device is the signal processing module, the primary unit further includes a power-on indicator module, the power-on indicator module includes a bi-color light-emitting diode LED100 and an MOS transistor Q210, a gate of the MOS transistor Q210 is connected to a BTA_CHAR interface of the primary unit charging management module, a source of the MOS transistor Q210 is connected to a positive power port of a USB interface, a drain of the MOS transistor Q210 is connected to one bi-color light-emitting diode LED100, and the other bi-color light-emitting diode LED100 is connected to a +9V power supply. When power is applied, a corresponding LED in the bi-color light-emitting diode LED100 lights up.

In the present embodiment, referring to Figs. 37 and 40, when the first signal processing device is the signal processing module, the primary unit further includes a switch SW11, an output port of the primary unit power management module is connected to a work indicator LED11 via the switch SW11, and the work indicator LED11 is connected to the signal transmitting module, so as to indicate a working condition of the primary unit.

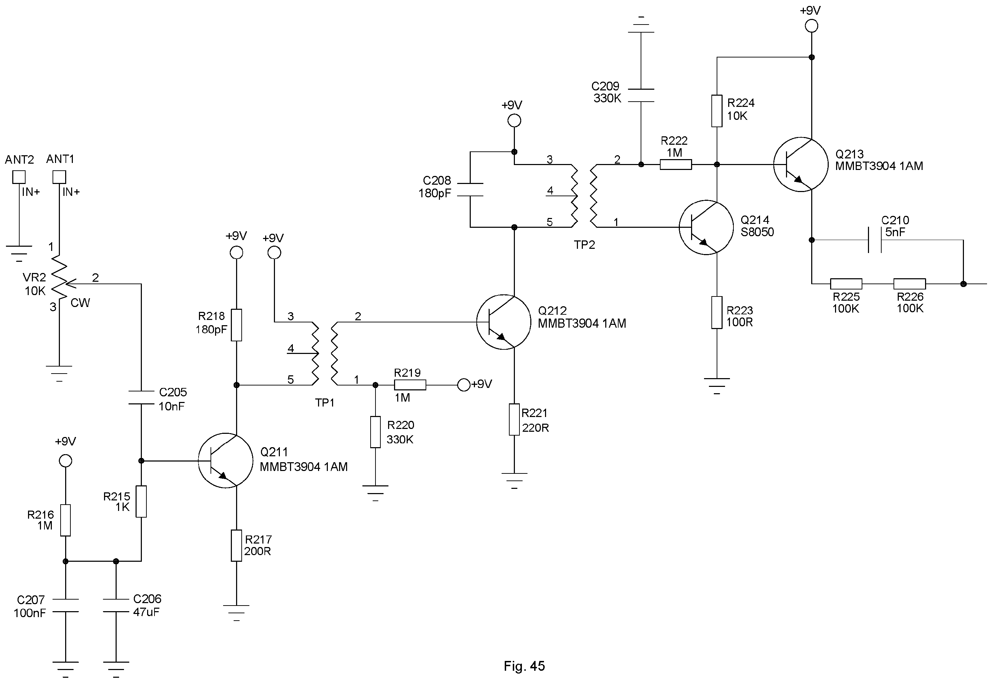

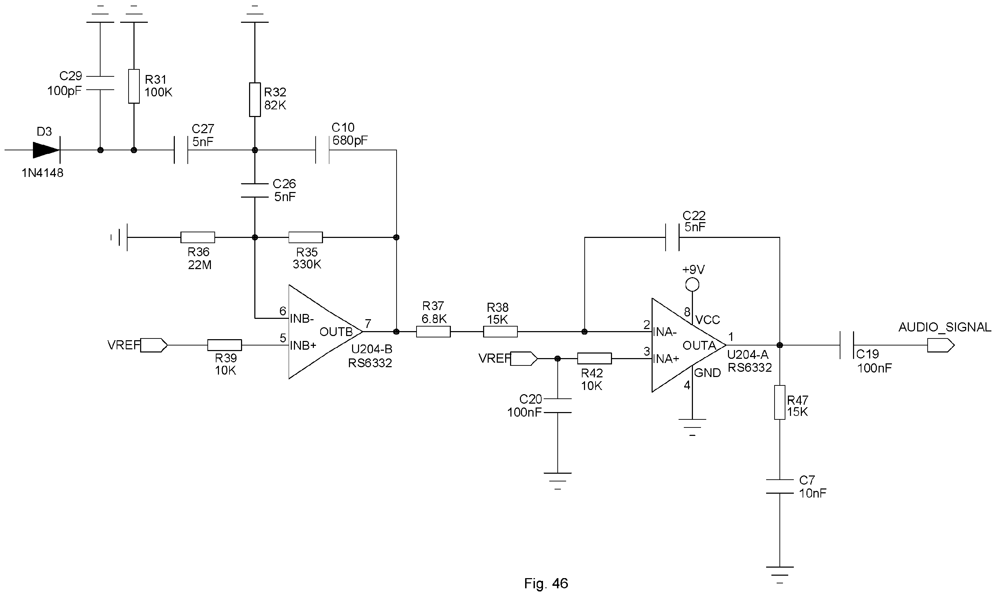

In the present embodiment, referring to Figs. 45 and 46, when the first signal processing device is the signal processing module, the probe interface is used to connect a signal receiving probe, the probe interface is grounded via a variable resistor VR2, a center tap of the variable resistor VR2 is grounded via a capacitor C205, a resistor R215, and a capacitor C206 sequentially connected in series, a resistor R216 and a capacitor C207 are connected in series between a +9V power supply and ground, a common end between the resistor R216 and the capacitor C207 is connected to a common end between the resistor R215 and the capacitor C206, the capacitor C205 and the resistor R215 are connected to a base of a transistor Q211, an emitter of the transistor Q211 is grounded via a resistor R217, a collector of the transistor Q211 is connected to a +9V power supply via a resistor R218, the collector of the transistor Q211 is connected to a port of a primary coil of an intermediate-frequency transformer TP1, an opposite port of the primary coil of the intermediate-frequency transformer TP1 is connected to a +9V power supply, a port of a secondary coil of the intermediate-frequency transformer TP1 is connected to a +9V power supply via a resistor R219, the same port thereof is further grounded via a resistor R220, an opposite port of the secondary coil of the intermediate-frequency transformer TP1 is connected to a base of a transistor Q212, an emitter of the transistor Q212 is grounded via a resistor R221, a collector of the transistor Q212 is connected to a port of a primary coil of the intermediate-frequency transformer TP2, an opposite port of the primary coil of the intermediate-frequency transformer TP2 is connected to a +9V power supply, a capacitor C208 is connected in parallel between two ports of the primary coil of the intermediate-frequency transformer TP2, a port of a secondary coil of the intermediate-frequency transformer TP2 is grounded via a capacitor C209, the same port thereof is further connected to a base of a transistor Q213 via a resistor R222, an opposite port of the secondary coil of the intermediate-frequency transformer TP2 is connected to a base of a transistor Q214, an emitter of the transistor Q214 is grounded via a resistor R223, a collector of the transistor Q214 is connected to a +9V power supply via a resistor R224, a collector of the transistor Q213 is connected to a +9V power supply, an emitter of the transistor Q213 is connected to the amplifier module via a resistor R225, a resistor R226, and a diode D3 connected in series, and the capacitor C210 is connected in parallel to the series-connected resistor R225 and the resistor R226. The intermediate-frequency transformer is a transformer with a fixed resonance circuit unique to the superheterodyne receiver. However, the resonance circuit may be fine-tuned within a certain range so that an accurate resonance frequency may still be achieved after accessing the circuit, and the fine-tuning is accomplished with the assistance of a fine-tuning capacitor or a change in the relative position of the magnetic core.

Referring to Figs. 44 and 46, input intermediate-frequency transformer TP1 and the output intermediate-frequency transformer TP2 select a frequency close to the emitted output signal, e.g., center frequency of 455KHz. The small signal detected by the probe is filtered and adjusted for frequency selection by the input intermediate-frequency transformer TP1 and the output intermediate-frequency transformer TP2 to obtain a pure received signal, and the signal is amplified under the action of the amplifier U204. The amplified signal accomplishes the conversion from an electrical signal to a sound signal under the action of the audio power amplifier U101 and the speaker.

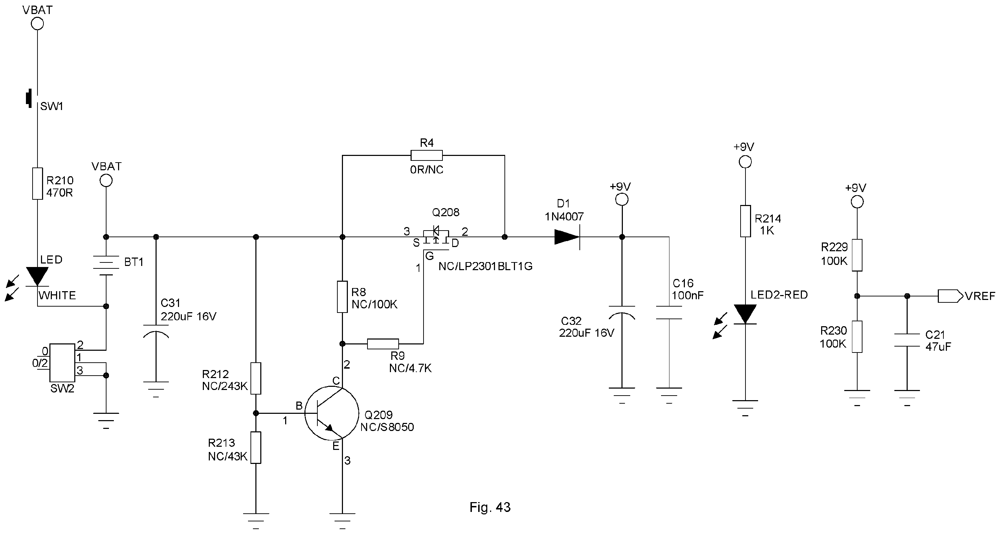

In the present embodiment, referring to Figs. 43 and 46, the amplifier module adopts a two-stage amplifier connected by the operational amplifier U204 of model RS6332, the output signal from the emitter of transistor Q212 is amplified and output to the alarm module, and the +9V power supply provides the reference voltage for the non-inverting input of the operational amplifier U204 after dividing the voltage via a voltage divider resistor R229 and a voltage divider resistor R230.

In the present embodiment, referring to Fig. 44, the alarm module includes an audio power amplifier U101 and a speaker BZ1, an output port of the amplifier module is connected to a signal input port of the audio power amplifier U101, and an output port of the audio power amplifier U101 is connected to the speaker BZ1.

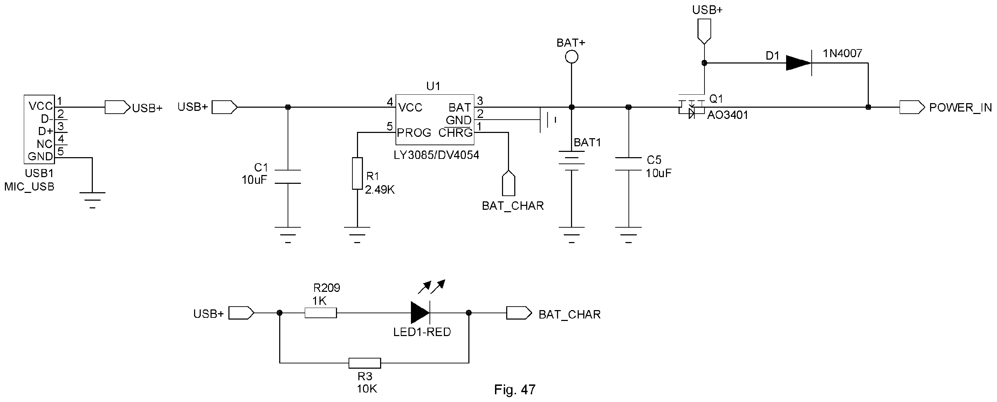

In the present embodiment, referring to Fig. 47, when the first signal processing device is the signal processing module, the secondary unit further includes a secondary unit charging indicator module, the secondary unit charging indicator module includes a resistor R209 and a light-emitting diode LED1-RED, and the resistor R209 and the light-emitting diode LED1-RED are connected in series between a BTA_CHAR interface of a secondary unit charging management module and a positive power port of a USB interface.

In the present embodiment, referring to Fig. 43, the secondary unit power module further includes a +9V battery, a switch SW1, a resistor R210, and a light-emitting diode LED are sequentially connected in series between a positive electrode and a negative electrode of the +9V battery, a switch SW2 is connected between the negative electrode of the +9V battery and ground, the positive electrode of the +9V battery is connected to a source of an MOS transistor Q208, a drain of the MOS transistor Q208 outputs a +9V power supply, a gate of the MOS transistor Q208 is connected to a collector of a transistor Q209 via a resistor R211, an emitter of the transistor Q209 is grounded, a base of the transistor Q209 is connected to a common end between a resistor R212 and a resistor R213, the resistor R212 and the resistor R213 are connected in series between the positive electrode of the +9V battery and ground, and a resistor R214 and a light-emitting diode LED2-RED are connected in series between the positive electrode of the +9V battery and ground.

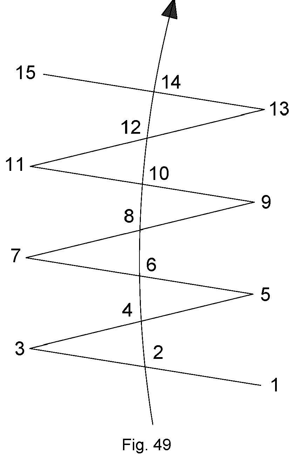

When the first signal processing device is the signal processing module, the principle of the test is to connect the emitting probe of the emitting circuit to a port of the underground cable, and add an audio signal to the underground cable, so that a magnetic field is generated around the underground cable under test and transmitted to the ground through the earth. Hold the receiver in your hand, let the probe hang freely, move the probe position, and the probe coil cuts the magnetic lines. As the distance from the underground cable is farther, the distribution of magnetic lines is sparser, and the received signal is weaker. Therefore, it is possible to determine an approximate location range of the underground cable with a larger sensitivity first, and then continuously reduce the sensitivity to narrow down the approximate location range of the underground cable again, and ultimately to determine the exact location of the underground cable. Referring to Fig. 49, the receiving circuit is able to receive a signal when it is at position 1. When the sensitivity is adjusted to a lower level, the signal will no longer be received at position 1. When moving the receiving probe towards the cable, the receiving circuit receives the signal again. By repeating the reduction of the sensitivity continuously again to the place where the signal is able to be received, it is possible to narrow down the possible range of the underground cables and finally confirm the location of the underground cables.

When in use, referring to Fig. 36 and 37, when the first signal processing device is the signal processing module, the tester includes signal emitting and signal receiving: when the emitting signal is emitted, the PWM wave (MCU_SCAN) with a specific frequency (455KHz) issued by the microcontroller is utilized to quickly and intermittently allow the MOS transistor Q207 to conduct and cut off, so as to amplify the output signal, and the MOS transistor Q204 and the MOS transistor Q205 adopt push-pull circuits, so as to reduce the conduction loss, improve the efficiency, and increase the circuit's loading capacity while also improving the switching speed. The signal is output to the transistor Q206 via the LC frequency selection network, where the signal is amplified under the action of the transistor Q206 and selected again under the action of the capacitor C202 and the inductor L203, and then the signal is output to the probe, where the size of the output signal is controlled by the variable resistor VR1 connected in series with the emitter of the transistor Q203. When receiving a signal, the receiving circuit takes the received weak signal and adjusts the signal sensitivity of the receiving circuit by means of the variable resistor VR1. The received signal is transmitted to the input intermediate-frequency transformer TP1, the input intermediate-frequency transformer TP1 serves to couple the signal transmitted from the probe to the resonant circuit, and to regulate the frequency selection (adjustments), and the loop inductance parameter achieves the effect of filtering out the interference and amplifying the size of the signal. The signal processed by the input intermediate-frequency transformer TP1 is coupled to the output intermediate-frequency transformer TP2, the output intermediate-frequency transformer TP2 mainly serves to change the turn relationship of the coils and change the phase balance of the speaker BZ1, so that the sound generated by the audio current discharged by the speaker BZ1 matches the waveforms received by the probe, resulting in a clear and noiseless audio output. The tiny signal processed by the output intermediate-frequency transformer TP2 needs to be amplified by the amplifier U4 and fed into the audio power amplifier U101, which then drives the speaker BZ1 to issue an audio alert.

The present invention may add a set frequency signal to the power grid, and the signal is received by the receiving probe and amplified, so as to test the underground cable path. The present disclosure achieves that regardless of whether the underground cable is charged or not, the cable path is detectable, which solves the inconvenient factors brought by the ordinary underground cable requirement of not being charged. The emitter and receiver are designed in a small and delicate structure, which is simple to operate and solves the deficiencies of the previous need for bulky instruments and equipment, the operation of many people and the need to find both ports of the target cable in order to determine the path of the cable. The present disclosure allows for accurate searching and detection of the path and depth of underground cables without destroying the ground.

## Claims

1. An underground cable path tester, comprising a primary unit and a secondary unit, wherein:
the primary unit comprises a primary unit central control module, a first signal processing device, a second signal processing device, and a primary unit power module, the first signal processing device is connected to a data port of the primary unit central control module, the second signal processing device is connected to an output port of the first signal processing device, the primary unit power module is used to supply power for the primary unit, the first signal processing device is a signal transmitting module, and the second signal processing device is a signal transmitting interface;
the secondary unit comprises a secondary unit processing device and a secondary unit power module, the secondary unit processing device comprises a first secondary unit processing device, the first secondary unit processing device corresponds to the signal transmitting module; the first secondary unit processing device comprises a secondary unit central control module, a signal receiving module, a signal amplifying module, and a phase-locked loop module, the signal receiving module is connected to the signal amplifying module, an output port of the signal amplifying module is connected to the phase-locked loop module, and the phase-locked loop module is connected to a data port of the secondary unit central control module;
**characterized in that**:
the signal receiving module comprises a first receiving coil (L31),a second receiving coil (L32), and a third receiving coil (L33); the first receiving coil (L31), the second receiving coil (L32), and the third
receiving coil (L33) are provided in an X-axis direction, a Y-axis direction, and a Z-axis direction, respectively; the signal amplifying module comprises an X-axis signal amplifying module, a Y-axis signal amplifying module, and a Z-axis signal amplifying module; and the phase-locked loop module comprises an X-axis phase-locked loop module, a Y-axis phase-locked loop module, and a Z-axis phase-locked loop module;
wherein, for any one direction among the X-axis direction, the Y-axis direction, and the Z-axis direction, the respective receiving coil in the respective direction is connected to the respective signal amplifying module, and then connected to the respective phase-locked loop module.

2. The underground cable path tester according to claim 1, wherein the first signal processing device comprises a dual-D flip-flop (U6), a first operational amplifier (U7), an electronic switch (U108), a first transistor (Q11), a second transistor (Q13), and an isolation transformer (TR1), an interior of the dual-D flip-flop (U6) comprises a first flip-flop (U6-A) and a second D flip-flop (U6-B), an interior of the first operational amplifier (U7) includes a second operational amplifier (U7-A) and a third operational amplifier (U7-B), a data port of the central control module is connected to an input port of the second D flip-flop (U6-B), an output port of the second D flip-flop (U6-B) is connected to an input port of the first D flip-flop (U6-A), an output port of the first D flip-flop (U6-A) is connected to an input port of the second operational amplifier (U7-A), an output port of the second operational amplifier (U7-A) is connected to an I/O port B of the electronic switch (U108), the I/O port B of the electronic switch (U108) is connected to an I/O port A of the electronic switch (U108), the I/O port A of the electronic switch (U108) is connected to an input port of the third operational amplifier (U7-B), a 9.0V power supply is connected to ground via a first resistor (R56) and a second resistor (R55), a common end between the first resistor (R56) and the second resistor (R55) is connected to the I/O port A of the electronic switch (U108), a collector of the first transistor (Q11) is connected to a 9.0V power supply, an emitter of the first transistor (Q11) is connected to an emitter of the second transistor (Q13), a collector of the second transistor (Q13) is grounded, a base of the first transistor (Q11) is connected to a base of second transistor (Q13), an output port of the third operational amplifier (U7-B) is connected to the base of the first transistor (Q11) and the base of the second transistor (Q13), the output port of the third operational amplifier (U7-B) is connected to the emitter of the first transistor (Q11) and the emitter of the second transistor (Q13) via a third resistor (R64), the emitter of the first transistor (Q11) and the emitter of the second transistor (Q13) are connected to a primary coil of the isolation transformer (TR1) through a capacitor (C11) and an inductor (L3) connected in series, and the secondary coil of the isolation transformer (TR1) is connected to an interface (J3-1).

3. The underground cable path tester according to claim 1, wherein a data port of the primary unit central control module is connected with a primary unit electronic control switch, the primary unit electronic control switch comprises a third transistor (Q31), a fourth transistor (Q32), and a fifth transistor (Q33), bases of the third transistor (Q31), the fourth transistor (Q32), and the fifth transistor (Q33) are connected to data ports of the primary unit central control module respectively, emitters of the third transistor (Q31), the fourth transistor (Q32), and the fifth transistor (Q33) are grounded respectively, and collectors of third transistor (Q31), the fourth transistor (Q32), and the fiftth transistor (Q33) are connected a control port of an electronic switch (U108) respectively.

4. The underground cable path tester according to claim 1, wherein the primary unit further comprises a signal feedback module, the signal feedback module comprises a fourth operational amplifier (U1), a fifth operational amplifier (U9), a sixth operational amplifier (U12-A), and a seventh operational amplifier (U12-B), the fourth operational amplifier (U1), the fifth operational amplifier (U9), the sixth operational amplifier (U12-A), and the seventh operational amplifier (U12-B) are connected in sequence to form a four-stage amplification system, a signal input port of the signal feedback module is connected to a primary coil of an isolation transformer (TR1), and an output port of the signal feedback module is connected to a data port of the primary unit central control module.

5. The underground cable path tester according to claim 1, wherein the X-axis signal amplifying module comprises an X-axis primary amplifying module and an X-axis secondary amplifying module, the Y-axis signal amplifying module comprises a Y-axis primary amplifying module and a Y-axis secondary amplifying module, the Z-axis signal amplifying module comprises a Z-axis primary amplifying module and a Z-axis secondary amplifying module, the first receiving coil (L31) is connected to an input port of the X-axis primary amplifying module, the X-axis primary amplifying module comprises an eighth operational amplifier (U1-A) and a ninth operational amplifier (U1-B), the eighth operational amplifier (U1-A) and the ninth operational amplifier (U1-B) are connected to form a two-stage amplification circuit, the X-axis primary amplifying module is connected to the X-axis secondary amplifying module via an interface (J1), the X-axis secondary amplifying module comprises a tenth operational amplifier (U8-A) and an eleventh operational amplifier (U8-B), the tenth operational amplifier (U8-A) and the eleventh operational amplifier (U8-B) are connected to form a two-stage amplification circuit, one branch of an output port of the X-axis secondary amplifying module is connected to a data port of the secondary unit central control module, another branch of the output port of the X-axis secondary amplifying module is connected to an input port of the X-axis phase-locked loop module, an output port of the X-axis phase-locked loop module is connected to a data port of the secondary unit central control module, a clock signal port of the X-axis phase-locked loop module is connected to an X-axis channel selector (U20), and a control port of the X-axis channel selector (U20) is connected to a data port of the secondary unit central control module;
the second receiving coil (L32) is connected to an input port of the Y-axis primary amplifying module, the Y-axis primary amplifying module comprises a twelfth operational amplifier (U2-A) and a thirteenth operational amplifier (U2-B), the twelfth operational amplifier (U2-A) and the thirteenth operational amplifier (U2-B) are connected to form a two-stage amplification circuit, the Y-axis primary amplifying module is connected to the Y-axis secondary amplifying module via an interface (J1), the Y-axis secondary amplifying module comprises a fourteenth operational amplifier (U9-A) and a fifteenth operational amplifier (U9-B), the fourteenth operational amplifier (U9-A) and the fifteenth operational amplifier (U9-B) are connected to form a two-stage amplification circuit, one branch of an output port of the Y-axis secondary amplifying module is connected to a data port of the secondary unit central control module, another branch of the output port of the Y-axis secondary amplifying module is connected to an input port of the Y-axis phase-locked loop module, an output port of the Y-axis phase-locked loop module is connected to a data port of the secondary unit central control module, a clock signal port of the Y-axis phase-locked loop module is connected to an Y-axis channel selector (U13), and a control port of the Y-axis channel selector (U13) is connected to a data port of the secondary unit central control module; and
the third receiving coil (L33) is connected to an input port of the Z-axis primary amplifying module, the Z-axis primary amplifying module comprises a sixteenth operational amplifier (U3-A) and a seventeenth operational amplifier (U3-B), the sixteenth operational amplifier (U3-A) and the seventeenth operational amplifier (U3-B) are connected to form a two-stage amplification circuit, the Z-axis primary amplifying module is connected to the Z-axis secondary amplifying module via an interface (J1), the Z-axis secondary amplifying module comprises an eighteenth operational amplifier (U10-A) and a nineteenth operational amplifier (U10-B), the eighteenth operational amplifier (U10-A) and the nineteenth operational amplifier (U10-B) are connected to form a two-stage amplification circuit, one branch of an output port of the Z-axis secondary amplifying module is connected to a data port of the secondary unit central control module, another branch of the output port of the Z-axis secondary amplifying module is connected to an input port of the Z-axis phase-locked loop module, an output port of the Z-axis phase-locked loop module is connected to a data port of the secondary unit central control module, a clock signal port of the Z-axis phase-locked loop module is connected to an Z-axis channel selector (U10), and a control port of the Z-axis channel selector (U10) is connected to a data port of the secondary unit central control module.

6. The underground cable path tester according to claim 1, wherein the secondary unit further comprises a wireless voltage detection module, the wireless voltage detection module comprises a non-contact voltage detection coil, a twentieth operational amplifier (U4-B), and a twenty-first operational amplifier (U14), the non-contact voltage detection coil is connected to an input port of the twentieth operational amplifier (U4-B), an output of the twentieth operational amplifier (U4-B) is connected to an input port of the twenty-first operational amplifier (U14), and an output port of the twenty-first operational amplifier (U14) is connected to a data port of the secondary unit central control module.

7. The underground cable path tester according to claim 1, wherein a data port of the secondary unit central control module is connected with an audio amplifier chip (U15), and an output port of the audio amplifier chip (U15) is connected with a speaker.

8. The underground cable path tester according to claim 1, wherein a crystal oscillator module is connected between an OSC_IN interface and an OSC_OUT interface of the primary unit central control module, and between an OSC_IN interface and an OSC_OUT interface of the secondary unit central control module respectively, a power-on reset module is connected to an NRST interface of the primary unit central control module and an NRST interface of the secondary unit central control module respectively, wherein the power-on reset module comprises a capacitor and a resistor, the capacitor is connected between ground and the NRST interface of the corresponding central control module, and the resistor is connected between a positive power supply and the NRST interface of the corresponding central control module;
a display module is connected to a data port of the primary unit central control module and a data port of the secondary unit central control module respectively;
a backlight module is connected to the data port of the primary unit central control module and the data port of the secondary unit central control module respectively, wherein the backlight module comprises a first current limiting resistor (R22), a first electronic control switch (Q10), and a backlight interface (CON2), the first current limiting resistor (R22), the backlight interface (CON2), and the first electronic control switch (Q10) are sequentially connected in series between the positive power supply and the ground, and a control port of the first electronic control switch (Q10) is connected to a data port of the corresponding central control module;
a key module is connected to the data port of the primary unit central control module and the data port of the secondary unit central control module respectively, wherein the key module comprises a first key switch (S1), a second key switch (S2), a third key switch (S3), a fourth key switch (S4), a fifth key switch (S5), a sixth key switch (S6), a seventh key switch (S7), and an eighth key switch (S8), and the first key switch (S1), the second key switch (S2), the third key switch (S3), the fourth key switch (S4), the fifth key switch (S5), the sixth key switch (S6), the seventh key switch (S7), and the eighth key switch (S8) are connected between the data port of the corresponding central control module and ground, respectively;
a buzzer module is connected to the data port of the primary unit central control module and the data port of the secondary unit central control module respectively, wherein the buzzer module comprises a buzzer and a second electronic control switch (Q12), the buzzer and the second electronic control switch (Q12) are connected in series between the positive power supply and ground, and a control port of the second electronic control switch (Q12) is connected to a data port of the corresponding central control module; and
a work indicator module is connected to the data port of the primary unit central control module and the data port of the secondary unit central control module respectively, wherein the work indicator module comprises a second current limiting resistor (R30), a third current limiting resistor (R31), a fourth current limiting resistor (R32), a third electronic control switch (Q9), a first indicator light (LED1), a second indicator light (LED2), and a third indicator light (LED3), the fourth current limiting resistor (R32) and the first indicator light (LED1) are connected in series, the third current limiting resistor (R31) and the second indicator light (LED2) are connected in series, the second current limiting resistor (R30) and the third indicator light (LED3) are connected in series, the series-connected fourth current limiting resistor (R32) and the first indicator light (LED1), the series-connected third current limiting resistor (R31) and the second indicator light (LED2), and the series-connected second current limiting resistor (R30) and the third indicator light (LED3) are connected in parallel and are connected between the positive power supply and ground via the third electronic control switch (Q9), and a control port of the third electronic control switch (Q9) is connected to a data port of the corresponding central control module.

9. The underground cable path tester according to claim 1, wherein the primary unit power module comprises a primary unit USB interface, a primary unit charging management module, a primary unit lithium battery, and a primary unit power management device, the primary unit USB interface is connected to a power input port of the primary unit charging management module, the primary unit lithium battery is connected to a power output port of the primary unit charging management module, and the primary unit lithium battery is charged via the primary unit USB interface;
a positive electrode of the primary unit lithium battery is connected with a primary unit battery voltage detection module, the primary unit battery voltage detection module comprises two resistors connected in series, and a common end between two resistors is connected to a data port of the primary unit central control module; when the first signal processing device is the signal transmitting module, a positive electrode of the secondary unit lithium battery is connected with a secondary unit battery voltage detection module, the secondary unit battery voltage detection module comprises two resistors connected in series, and a common end between two resistors is connected to a data port of the secondary unit central control module; when the first signal processing device is a signal transmitting module, the primary unit power management device comprises a primary unit boost chip (U105) and a primary unit voltage regulator chip (U104), a power input port of the primary unit boost chip (U105) is connected to the primary unit lithium battery, a voltage of the primary unit lithium battery is converted to +9.0V for power supply via the primary unit boost chip (U105), and +9.0V voltage is regulated to +3.3V via the primary unit voltage regulator chip (U104) and then output to the primary unit for power supply.

10. The underground cable path tester according to claim 1, wherein: the secondary unit power module comprises a secondary unit USB interface, a secondary unit charging management module, a secondary unit lithium battery, and a secondary unit power management device, the secondary unit USB interface is connected to a power input port of the secondary unit charging management module, the secondary unit lithium battery is connected to a power output port of the secondary unit charging management module, and the secondary unit lithium battery is charged via the secondary unit USB interface;
the secondary unit power management device comprises an MOSFET chip (Q106), a secondary unit boost chip (U102), a first secondary unit voltage regulator chip (U114), and a second secondary unit voltage regulator chip (U116), a power input port of the secondary unit boost chip (U102) is connected to the secondary unit lithium battery via the MOSFET chip (Q106), a voltage of the secondary unit lithium battery is converted to +9.0V for power supply via the secondary unit boost chip (U102), +9.0V voltage is regulated to +5.0V via the first secondary unit voltage regulator chip (U114) and then output to the secondary unit for power supply, and a voltage of the secondary unit lithium battery is regulated to +3.3V via the second secondary unit voltage regulator chip (U116) and then output to the secondary unit for power supply.

## Patentansprüche

1. Unterirdische Kabelwegprüfvorrichtung, umfassend eine Primäreinheit und eine Sekundäreinheit, wobei:
die Primäreinheit ein zentrales Steuermodul der Primäreinheit, eine erste Signalverarbeitungsvorrichtung, eine zweite Signalverarbeitungsvorrichtung und ein Leistungsmodul der Primäreinheit umfasst, die erste Signalverarbeitungsvorrichtung mit einem Datenanschluss des zentralen Steuermoduls der Primäreinheit verbunden ist, die zweite Signalverarbeitungsvorrichtung mit einem Ausgangsanschluss der ersten Signalverarbeitungsvorrichtung verbunden ist, das Leistungsmodul der Primäreinheit zur Stromversorgung der Primäreinheit dient, die erste Signalverarbeitungsvorrichtung ein Signalübertragungsmodul ist und die zweite Signalverarbeitungsvorrichtung eine Signalübertragungsschnittstelle ist; die Sekundäreinheit eine Verarbeitungsvorrichtung der Sekundäreinheit und ein Leistungsmodul der Sekundäreinheit umfasst, die Verarbeitungsvorrichtung der Sekundäreinheit eine erste Verarbeitungsvorrichtung der Sekundäreinheit umfasst, die erste Verarbeitungsvorrichtung der Sekundäreinheit dem Signalübertragungsmodul entspricht;
die erste Verarbeitungsvorrichtung der Sekundäreinheit ein zentrales Steuermodul der Sekundäreinheit, ein Signalempfangsmodul, ein Signalverstärkungsmodul und ein Phasenregelschleifenmodul umfasst, das Signalempfangsmodul mit dem Signalverstärkungsmodul verbunden ist, ein Ausgangsanschluss des Signalverstärkungsmoduls mit dem Phasenregelschleifenmodul verbunden ist und das Phasenregelschleifenmodul mit einem Datenanschluss des zentralen Steuermoduls der Sekundäreinheit verbunden ist;
**dadurch gekennzeichnet, dass**:
das Signalempfangsmodul eine erste Empfangsspule (L31), eine zweite Empfangsspule (L32) und eine dritte Empfangsspule (L33) umfasst; die erste Empfangsspule (L31), die zweite Empfangsspule (L32) und die dritte Empfangsspule (L33) in einer X-Achsenrichtung, einer Y-Achsenrichtung und einer Z-Achsenrichtung vorgesehen sind; das Signalverstärkungsmodul ein Signalverstärkungsmodul der X-Achse, ein Signalverstärkungsmodul der Y-Achse und ein Signalverstärkungsmodul der Z-Achse umfasst; und das Phasenregelschleifenmodul ein Phasenregelschleifenmodul der X-Achse, ein Phasenregelschleifenmodul der Y-Achse und ein Phasenregelschleifenmodul der Z-Achse umfasst;
wobei für eine beliebige Richtung zwischen der X-Achsenrichtung, der Y-Achsenrichtung und der Z-Achsenrichtung die jeweilige Empfangsspule in der jeweiligen Richtung mit dem jeweiligen Signalverstärkungsmodul verbunden ist und dann mit dem jeweiligen Phasenregelschleifenmodul verbunden ist.

2. Unterirdische Kabelwegprüfvorrichtung nach Anspruch 1, wobei die erste Signalverarbeitungsvorrichtung ein Dual-D-Flip-Flop (U6), einen ersten Betriebsverstärker (U7), einen elektronischen Schalter (U108), einen ersten Transistor (Q11), einen zweiten Transistor (Q13) und einen Trenntransformator (TR1) umfasst, ein Innenraum des Dual-D-Flip-Flops (U6) ein erstes D-Flip-Flop (U6-A) und ein zweites D-Flip-Flop (U6-B) umfasst, ein Innenraum des ersten Betriebsverstärkers (U7) einen zweiten Betriebsverstärker (U7-A) und einen dritten Betriebsverstärker (U7-B) einschließt, ein Datenanschluss des zentralen Steuermoduls mit einem Eingangsanschluss des zweiten D-Flip-Flops (U6-B) verbunden ist, ein Ausgangsanschluss des zweiten D-Flip-Flops (U6-B) mit einem Eingangsanschluss des ersten D-Flip-Flops (U6-A) verbunden ist, ein Ausgangsanschluss des ersten D-Flip-Flops (U6-A) mit einem Eingangsanschluss des zweiten Betriebsverstärkers (U7-A) verbunden ist, ein Ausgangsanschluss des zweiten Betriebsverstärkers (U7-A) mit einem E/A-Anschluss B des elektronischen Schalters (U108) verbunden ist, der E/A-Anschluss B des elektronischen Schalters (U108) mit einem E/A-Anschluss A des elektronischen Schalters (U108) verbunden ist, der E/A-Anschluss A des elektronischen Schalters (U108) mit einem Eingangsanschluss des dritten Betriebsverstärkers (U7-B) verbunden ist, eine 9,0-V-Stromversorgung über einen ersten Widerstand (R56) und einen zweiten Widerstand (R55) mit Masse verbunden ist, ein gemeinsames Ende zwischen dem ersten Widerstand (R56) und dem zweiten Widerstand (R55) mit dem E/A-Anschluss A des elektronischen Schalters (U108) verbunden ist, ein Stromabnehmer des ersten Transistors (Q11) mit einer 9,0-V-Stromversorgung verbunden ist, ein Emitter des ersten Transistors (Q11) mit einem Emitter des zweiten Transistors (Q13) verbunden ist, ein Stromabnehmer des zweiten Transistors (Q13) geerdet ist, eine Basis des ersten Transistors (Q11) mit einer Basis des zweiten Transistors (Q13) verbunden ist, ein Ausgangsanschluss des dritten Betriebsverstärkers (U7-B) mit der Basis des ersten Transistors (Q11) und der Basis des zweiten Transistors (Q13) verbunden ist, der Ausgangsanschluss des dritten Betriebsverstärkers (U7-B) über einen dritten Widerstand (R64) mit dem Emitter des ersten Transistors (Q11) und dem Emitter des zweiten Transistors (Q13) verbunden ist, der Emitter des ersten Transistors (Q11) und der Emitter des zweiten Transistors (Q13) über einen Kondensator (C11) und einen Induktor (L3), die in Reihe geschaltet sind, mit einer Primärspule des Trenntransformators (TR1) verbunden sind, und die Sekundärspule des Trenntransformators (TR1) mit einer Schnittstelle (J3-1) verbunden ist.

3. Unterirdische Kabelwegprüfvorrichtung nach Anspruch 1, wobei ein Datenanschluss des zentralen Steuermoduls der Primäreinheit mit einem elektronischen Steuerschalter der Primäreinheit verbunden ist, der elektronische Steuerschalter der Primäreinheit einen dritten Transistor (Q31), einen vierten Transistor (Q32) und einen fünften Transistor (Q33) umfasst, die Basen des dritten Transistors (Q31), des vierten Transistors (Q32) und des fünften Transistors (Q33) jeweils mit Datenanschlüssen des zentralen Steuermoduls der Primäreinheit verbunden sind, Emitter des dritten Transistors (Q31), des vierten Transistors (Q32) und des fünften Transistors (Q33) jeweils geerdet sind, und Stromabnehmern des dritten Transistors (Q31), des vierten Transistors (Q32) und des fünften Transistors (Q33) jeweils mit einem Steueranschluss eines elektronischen Schalters (U108) verbunden sind.

4. Unterirdische Kabelwegprüfvorrichtung nach Anspruch 1, wobei die Primäreinheit ferner ein Signalrückmeldemodul umfasst, das Signalrückmeldemodul einen vierten Betriebsverstärker (U1), einen fünften Betriebsverstärker (U9), einen sechsten Betriebsverstärker (U12-A) und einen siebten Betriebsverstärker (U12-B) umfasst, der vierte Betriebsverstärker (U1), der fünfte Betriebsverstärker (U9), der sechste Betriebsverstärker (U12-A) und der siebte Betriebsverstärker (U12-B) in Reihe geschaltet sind, um ein vierstufiges Verstärkungssystem zu bilden, ein Signaleingangsanschluss des Signalrückmeldemoduls mit einer Primärspule eines Trenntransformators (TR1) verbunden ist, und ein Ausgangsanschluss des Signalrückmeldemoduls mit einem Datenanschluss des zentralen Steuermoduls der Primäreinheit verbunden ist.

5. Unterirdische Kabelwegprüfvorrichtung nach Anspruch 1, wobei das Signalverstärkungsmodul der X-Achse ein Primärverstärkungsmodul der X-Achse und ein Sekundärverstärkungsmodul der X-Achse umfasst, das Signalverstärkungsmodul der Y-Achse ein Primärverstärkungsmodul der Y-Achse und ein Sekundärverstärkungsmodul der Y-Achse umfasst, das Signalverstärkungsmodul der Z-Achse ein Primärverstärkungsmodul der Z-Achse und ein Sekundärverstärkungsmodul der Z-Achse umfasst, die erste Empfangsspule (L31) mit einem Eingangsanschluss des Primärverstärkungsmoduls der X-Achse verbunden ist, das Primärverstärkungsmodul der X-Achse einen achten Betriebsverstärker (U1-A) und einen neunten Betriebsverstärker (U1-B) umfasst, der achte Betriebsverstärker (U1-A) und der neunte Betriebsverstärker (U1-B) verbunden sind, um eine zweistufige Verstärkungsschaltung zu bilden, das Primärverstärkungsmodul der X-Achse über eine Schnittstelle (J1) mit dem Sekundärverstärkungsmodul der X-Achse verbunden ist, das Sekundärverstärkungsmodul der X-Achse einen zehnten Betriebsverstärker (U8-A) und einen elften Betriebsverstärker (U8-B) umfasst, der zehnte Betriebsverstärker (U8-A) und der elfte Betriebsverstärker (U8-B) verbunden sind, um eine zweistufige Verstärkungsschaltung zu bilden, ein Zweig eines Ausgangsanschlusses des Sekundärverstärkungsmoduls der X-Achse mit einem Datenanschluss des zentralen Steuermoduls der Sekundäreinheit verbunden ist, ein weiterer Zweig des Ausgangsanschlusses des Sekundärverstärkungsmoduls der X-Achse mit einem Eingangsanschluss des Phasenregelschleifenmoduls der X-Achse verbunden ist, ein Ausgangsanschluss des Phasenregelschleifenmoduls der X-Achse mit einem Datenanschluss des zentralen Steuermoduls der Sekundäreinheit verbunden ist, ein Taktsignalanschluss des Phasenregelschleifenmoduls der X-Achse mit einem Kanalwähler der X-Achse (U20) verbunden ist und ein Steueranschluss des Kanalwählers der X-Achse (U20) mit einem Datenanschluss des zentralen Steuermoduls der Sekundäreinheit verbunden ist;
die zweite Empfangsspule (L32) mit einem Eingangsanschluss des Primärverstärkungsmoduls der Y-Achse verbunden ist, das Primärverstärkungsmodul der Y-Achse einen zwölften Betriebsverstärker (U2-A) und einen dreizehnten Betriebsverstärker (U2-B) umfasst, der zwölfte Betriebsverstärker (U2-A) und der dreizehnte Betriebsverstärker (U2-B) verbunden sind, um eine zweistufige Verstärkungsschaltung zu bilden, das Primärverstärkungsmodul der Y-Achse über eine Schnittstelle (J1) mit dem Sekundärverstärkungsmodul der Y-Achse verbunden ist, das Sekundärverstärkungsmodul der Y-Achse einen vierzehnten Betriebsverstärker (U9-A) und einen fünfzehnten Betriebsverstärker (U9-B) umfasst, der vierzehnte Betriebsverstärker (U9-A) und der fünfzehnte Betriebsverstärker (U9-B) verbunden sind, um eine zweistufige Verstärkungsschaltung zu bilden, ein Zweig eines Ausgangsanschlusses des Sekundärverstärkungsmodul der Y-Achses mit einem Datenanschluss des zentralen Steuermoduls der Sekundäreinheit verbunden ist, ein weiterer Zweig des Ausgangsanschlusses des Sekundärverstärkungsmoduls der Y-Achse mit einem Eingangsanschluss des Phasenregelschleifenmoduls der Y-Achse verbunden ist, ein Ausgangsanschluss des Phasenregelschleifenmoduls der Y-Achse mit einem Datenanschluss des zentralen Steuermoduls der Sekundäreinheit verbunden ist, ein Taktsignalanschluss des Phasenregelschleifenmoduls der Y-Achse mit einem Kanalwähler der Y-Achse (U13) verbunden ist, und ein Steueranschluss des Kanalwählers der Y-Achse (U13) mit einem Datenanschluss des zentralen Steuermoduls der Sekundäreinheit verbunden ist; und
die dritte Empfangsspule (L33) mit einem Eingangsanschluss des Primärverstärkungsmoduls der Z-Achse verbunden ist, das Primärverstärkungsmodul der Z-Achse einen sechzehnten Betriebsverstärker (U3-A) und einen siebzehnten Betriebsverstärker (U3-B) umfasst, der sechzehnte Betriebsverstärker (U3-A) und der siebzehnte Betriebsverstärker (U3-B) verbunden sind, um eine zweistufige Verstärkungsschaltung zu bilden, das Primärverstärkungsmodul der Z-Achse über eine Schnittstelle (J1) mit dem Sekundärverstärkungsmodul der Z-Achse verbunden ist, das Sekundärverstärkungsmodul der Z-Achse einen achtzehnten Betriebsverstärker (U10-A) und einen neunzehnten Betriebsverstärker (U10-B) umfasst, der achtzehnte Betriebsverstärker (U10-A) und der neunzehnte Betriebsverstärker (U10-B) verbunden sind, um eine zweistufige Verstärkungsschaltung zu bilden, ein Zweig eines Ausgangsanschlusses des Sekundärverstärkungsmoduls der Z-Achse mit einem Datenanschluss des zentralen Steuermoduls der Sekundäreinheit verbunden ist, ein weiterer Zweig des Ausgangsanschlusses des Sekundärverstärkungsmoduls der Z-Achse mit einem Eingangsanschluss des Phasenregelschleifenmoduls der Z-Achse verbunden ist, ein Ausgangsanschluss des Phasenregelschleifenmoduls der Z-Achse mit einem Datenanschluss des zentralen Steuermoduls der Sekundäreinheit verbunden ist, ein Taktsignalanschluss des Phasenregelschleifenmoduls der Z-Achse mit einem Kanalwähler der Z-Achse (U10) verbunden ist, und ein Steueranschluss des Kanalwählers der Z-Achse (U10) mit einem Datenanschluss des zentralen Steuermoduls der Sekundäreinheit verbunden ist.

6. Unterirdische Kabelwegprüfvorrichtung nach Anspruch 1, wobei die Sekundäreinheit ferner ein drahtloses Spannungserkennungsmodul umfasst, das drahtlose Spannungserkennungsmodul eine berührungslose Spannungserkennungsspule, einen zwanzigsten Betriebsverstärker (U4-B) und einen einundzwanzigsten Betriebsverstärker (U14) umfasst, die berührungslose Spannungserkennungsspule mit einem Eingangsanschluss des zwanzigsten Betriebsverstärkers (U4-B) verbunden ist, ein Ausgang des zwanzigsten Betriebsverstärkers (U4-B) mit einem Eingangsanschluss des einundzwanzigsten Betriebsverstärkers (U14) verbunden ist, und ein Ausgangsanschluss des einundzwanzigsten Betriebsverstärkers (U14) mit einem Datenanschluss des zentralen Steuermoduls der Sekundäreinheit verbunden ist.

7. Unterirdische Kabelwegprüfvorrichtung nach Anspruch 1, wobei ein Datenanschluss des zentralen Steuermoduls der Sekundäreinheit mit einem Audioverstärker-Chip (U15) verbunden ist und ein Ausgangsanschluss des Audioverstärker-Chips (U15) mit einem Lautsprecher verbunden ist.

8. Unterirdische Kabelwegprüfvorrichtung nach Anspruch 1, wobei ein Kristalloszillatormodul zwischen einer OSC_IN-Schnittstelle und einer OSC_OUT-Schnittstelle des zentralen Steuermoduls der Primäreinheit bzw. zwischen einer OSC_IN-Schnittstelle und einer OSC_OUT-Schnittstelle des zentralen Steuermoduls der Sekundäreinheit angeschlossen ist, ein Einschalt-Reset-Modul mit einer NRST-Schnittstelle des zentralen Steuermoduls der Primäreinheit bzw. einer NRST-Schnittstelle des zentralen Steuermoduls der Sekundäreinheit verbunden ist, wobei das Einschalt-Reset-Modul einen Kondensator und einen Widerstand umfasst, der Kondensator zwischen Masse und der NRST-Schnittstelle des entsprechenden zentralen Steuermoduls verbunden ist, und der Widerstand zwischen einer positiven Stromversorgung und der NRST-Schnittstelle des entsprechenden zentralen Steuermoduls verbunden ist;
ein Anzeigemodul mit einem Datenanschluss des zentralen Steuermoduls der Primäreinheit bzw. einem Datenanschluss des zentralen Steuermoduls der Sekundäreinheit verbunden ist;
ein Hintergrundbeleuchtungsmodul mit dem Datenanschluss des zentralen Steuermoduls der Primäreinheit und dem Datenanschluss des zentralen Steuermoduls der Sekundäreinheit verbunden ist, wobei das Hintergrundbeleuchtungsmodul einen ersten Strombegrenzungswiderstand (R22), einen ersten elektronischen Steuerschalter (Q10) und eine Hintergrundbeleuchtungsschnittstelle (CON2) umfasst, der erste Strombegrenzungswiderstand (R22), die Hintergrundbeleuchtungsschnittstelle (CON2) und der erste elektronische Steuerschalter (Q10) zwischen der positiven Spannungsversorgung und Masse in Reihe geschaltet sind, und ein Steueranschluss des ersten elektronischen Steuerschalters (Q10) mit einem Datenanschluss des entsprechenden zentralen Steuermoduls verbunden ist;
ein Tastenmodul mit dem Datenanschluss des zentralen Steuermoduls der Primäreinheit und dem Datenanschluss des zentralen Steuermoduls der Sekundäreinheit verbunden ist, wobei das Tastenmodul einen ersten Tastenschalter (S1), einen zweiten Tastenschalter (S2), einen dritten Tastenschalter (S3), einen vierten Tastenschalter (S4), einen fünften Tastenschalter (S5), einen sechsten Tastenschalter (S6), einen siebten Tastenschalter (S7) und einen achten Tastenschalter (S8) umfasst, und der erste Tastenschalter (S1), der zweite Tastenschalter (S2), der dritte Tastenschalter (S3), der vierte Tastenschalter (S4), der fünfte Tastenschalter (S5), der sechste Tastenschalter (S6), der siebte Tastenschalter (S7) und der achte Tastenschalter (S8) jeweils zwischen dem Datenanschluss des entsprechenden zentralen Steuermoduls und Masse angeschlossen sind;
ein Summermodul mit dem Datenanschluss des zentralen Steuermoduls der Primäreinheit bzw. dem Datenanschluss des zentralen Steuermoduls der Sekundäreinheit verbunden ist, wobei das Summermodul einen Summer und einen zweiten elektronischen Steuerschalter (Q12) umfasst, der Summer und der zweite elektronische Steuerschalter (Q12) zwischen der positiven Stromversorgung und Masse in Reihe geschaltet sind, und ein Steueranschluss des zweiten elektronischen Steuerschalters (Q12) mit einem Datenanschluss des entsprechenden zentralen Steuermoduls verbunden ist; und
ein Arbeitsanzeigemodul mit dem Datenanschluss des zentralen Steuermoduls der Primäreinheit bzw. mit dem Datenanschluss des zentralen Steuermoduls der Sekundäreinheit verbunden ist, wobei das Arbeitsanzeigemodul einen zweiten Strombegrenzungswiderstand (R30), einen dritten Strombegrenzungswiderstand (R31), einen vierten Strombegrenzungswiderstand (R32), einen dritten elektronischen Steuerschalter (Q9), eine erste Anzeigeleuchte (LED1), eine zweite Anzeigeleuchte (LED2) und eine dritte Anzeigeleuchte (LED3) umfasst, der vierte Strombegrenzungswiderstand (R32) und die erste Anzeigeleuchte (LED1) in Reihe geschaltet sind, der dritte Strombegrenzungswiderstand (R31) und die zweite Anzeigeleuchte (LED2) in Reihe geschaltet sind, der zweite Strombegrenzungswiderstand (R30) und die dritte Anzeigeleuchte (LED3) in Reihe geschaltet sind, der vierte Strombegrenzungswiderstand (R32) und die erste Anzeigeleuchte (LED1), die in Reihe geschaltet sind, der dritte Strombegrenzungswiderstand (R31) und die zweite Anzeigeleuchte (LED2), die in Reihe geschaltet sind, und der zweite Strombegrenzungswiderstand (R30) und die dritte Anzeigeleuchte (LED3), die in Reihe geschaltet sind, parallel geschaltet und über den dritten elektronischen Steuerschalter (Q9) zwischen der positiven Spannungsversorgung und Masse verbunden sind, und ein Steueranschluss des dritten elektronischen Steuerschalters (Q9) mit einem Datenanschluss des entsprechenden zentralen Steuermoduls verbunden ist.

9. Unterirdische Kabelwegprüfvorrichtung nach Anspruch 1, wobei das Leistungsmodul der Primäreinheit eine USB-Schnittstelle der Primäreinheit, ein Lademanagementmodul der Primäreinheit, eine Lithiumbatterie der Primäreinheit und eine Strommanagementvorrichtung der Primäreinheit umfasst, die USB-Schnittstelle der Primäreinheit mit einem Stromeingangsanschluss des Lademanagementmoduls der Primäreinheit verbunden ist, die Lithiumbatterie der Primäreinheit mit einem Stromausgangsanschluss des Lademanagementmoduls der Primäreinheit verbunden ist, und die Lithiumbatterie der Primäreinheit über die USB-Schnittstelle der Primäreinheit geladen wird;
eine positive Elektrode der Lithiumbatterie der Primäreinheit mit einem Batteriespannungserkennungsmodul der Primäreinheit verbunden ist, das Batteriespannungserkennungsmodul der Primäreinheit zwei in Reihe geschaltete Widerstände umfasst und ein gemeinsames Ende zwischen zwei Widerständen mit einem Datenanschluss des zentralen Steuermoduls der Primäreinheit verbunden ist; wenn die erste Signalverarbeitungsvorrichtung das Signalübertragungsmodul ist, eine positive Elektrode der Lithiumbatterie der Sekundäreinheit mit einem Batteriespannungserkennungsmodul der Sekundäreinheit verbunden ist, das Batteriespannungserkennungsmodul der Sekundäreinheit zwei in Reihe geschaltete Widerstände umfasst und ein gemeinsames Ende zwischen zwei Widerständen mit einem Datenanschluss des zentralen Steuermoduls der Sekundäreinheit verbunden ist; wenn die erste Signalverarbeitungsvorrichtung ein Signalübertragungsmodul ist, die Strommanagementvorrichtung der Primäreinheit einen Boost-Chip der Primäreinheit (U105) und einen Spannungsregler-Chip der Primäreinheit (U104) umfasst, ein Stromeingangsanschluss des Boost-Chips der Primäreinheit (U105) mit der Lithiumbatterie der Primäreinheit verbunden ist, eine Spannung der Lithiumbatterie der Primäreinheit über den Boost-Chip der Primäreinheit (U105) auf +9,0 V zur Stromversorgung umgewandelt wird, und eine Spannung von +9,0 V über den Spannungsregler-Chip der Primäreinheit (U104) auf +3,3 V geregelt und dann zur Spannungsversorgung an die Primäreinheit ausgegeben wird.

10. Unterirdische Kabelwegprüfvorrichtung nach Anspruch 1, wobei: das Leistungsmodul der Sekundäreinheit eine USB-Schnittstelle der Sekundäreinheit, ein Lademanagementmodul der Sekundäreinheit, eine Lithiumbatterie der Sekundäreinheit und eine Strommanagementvorrichtung der Sekundäreinheit umfasst, die USB-Schnittstelle der Sekundäreinheit mit einem Stromeingangsanschluss des Lademanagementmoduls der Sekundäreinheit verbunden ist, die Lithiumbatterie der Sekundäreinheit mit einem Stromausgangsanschluss des Lademanagementmoduls der Sekundäreinheit verbunden ist, und die Lithiumbatterie der Sekundäreinheit über die USB-Schnittstelle der Sekundäreinheit geladen wird;
die Strommanagementvorrichtung der Sekundäreinheit einen MOSFET-Chip (Q106), einen Boost-Chip der Sekundäreinheit (U102), einen ersten Spannungsregler-Chip der Sekundäreinheit (U114) und einen zweiten Spannungsregler-Chip der Sekundäreinheit (U116) umfasst, ein Stromeingangsanschluss des Boost-Chips der Sekundäreinheit (U102) über den MOSFET-Chip (Q106) mit der Lithiumbatterie der Sekundäreinheit verbunden ist, eine Spannung der Lithiumbatterie der Sekundäreinheit über den Boost-Chip der Sekundäreinheit (U102) auf +9,0 V zur Stromversorgung umgewandelt wird, eine Spannung von +9,0 V über den ersten Spannungsregler-Chip der Sekundäreinheit (U114) auf +5,0 V geregelt und dann zur Spannungsversorgung an die Sekundäreinheit ausgegeben wird, und eine Spannung der Lithiumbatterie der Sekundäreinheit über den zweiten Spannungsregler-Chip der Sekundäreinheit (U116) auf +3,3 V geregelt und dann zur Spannungsversorgung an die Sekundäreinheit ausgegeben wird.

## Revendications

1. Testeur de chemin de câbles souterrain, comportant une unité primaire et une unité secondaire, dans lequel :
l'unité primaire comporte un module de commande central d'unité primaire, un premier dispositif de traitement de signal, un deuxième dispositif de traitement de signal, et un module de puissance d'unité primaire, le premier dispositif de traitement de signal est connecté à un port de données du module de commande central d'unité primaire, le deuxième dispositif de traitement de signal est connecté à un port de sortie du premier dispositif de traitement de signal, le module de puissance d'unité primaire est utilisé pour alimenter l'unité primaire, le premier dispositif de traitement de signal est un module de transmission de signal, et le deuxième dispositif de traitement de signal est une interface de transmission de signal ; l'unité secondaire comporte un dispositif de traitement d'unité secondaire et un module de puissance d'unité secondaire, le dispositif de traitement d'unité secondaire comporte un premier dispositif de traitement d'unité secondaire, le premier dispositif de traitement d'unité secondaire correspond au module de transmission de signal ;
le premier dispositif de traitement d'unité secondaire comporte un module de commande central d'unité secondaire, un module de réception de signal, un module d'amplification de signal et un module à boucle à verrouillage de phase, le module de réception de signal est connecté au module d'amplification de signal, un port de sortie du module d'amplification de signal est connecté au module à boucle à verrouillage de phase, et le module à boucle à verrouillage de phase est connecté à un port de données du module de commande central d'unité secondaire ;
**caractérisé en ce que** :
le module de réception de signal comporte une première bobine de réception (L31), une deuxième bobine de réception (L32), et une troisième bobine de réception (L33) ; la première bobine de réception (L31), la deuxième bobine de réception (L32), et la troisième bobine de réception (L33) sont disposées dans une direction d'axe X, une direction d'axe Y et une direction d'axe Z, respectivement ; le module d'amplification de signal comporte un module d'amplification de signal d'axe X, un module d'amplification de signal d'axe Y, et un module d'amplification de signal d'axe Z ; et le module à boucle à verrouillage de phase comporte un module à boucle à verrouillage de phase d'axe X, un module à boucle à verrouillage de phase d'axe Y, et un module à boucle à verrouillage de phase d'axe Z ;
dans lequel, pour une direction quelconque parmi la direction de l'axe X, la direction de l'axe Y, et la direction de l'axe Z, la bobine de réception respective dans la direction respective est connectée au module d'amplification de signal respectif, puis connectée au module à boucle à verrouillage de phase respectif.

2. Testeur de chemin de câbles souterrain selon la revendication 1, dans lequel le premier dispositif de traitement de signal comporte une bascule double D (U6), un premier amplificateur opérationnel (U7), un commutateur électronique (U108), un premier transistor (Q11), un deuxième transistor (Q13), et un transformateur d'isolement (TR1), un intérieur de la bascule double D (U6) comporte une première bascule D (U6-A) et une deuxième bascule D (U6-B), un intérieur du premier amplificateur opérationnel (U7) comporte un deuxième amplificateur opérationnel (U7-A) et un troisième amplificateur opérationnel (U7-B), un port de données du module de commande central est connecté à un port d'entrée de la deuxième bascule D (U6-B), un port de sortie de la deuxième bascule D (U6-B) est connecté à un port d'entrée de la première bascule D (U6-A), un port de sortie de la première bascule D (U6-A) est connecté à un port d'entrée du deuxième amplificateur opérationnel (U7-A), un port de sortie du deuxième amplificateur opérationnel (U7-A) est connecté à un port E/S B du commutateur électronique (U108), le port E/S B du commutateur électronique (U108) est connecté à un port E/S A du commutateur électronique (U108), le port E/S A du commutateur électronique (U108) est connecté à un port d'entrée du troisième amplificateur opérationnel (U7-B), une alimentation électrique de 9,0 V est connectée à la terre via une première résistance (R56) et une deuxième résistance (R55), une extrémité commune entre la première résistance (R56) et la deuxième résistance (R55) est connectée au port E/S A du commutateur électronique (U108), un collecteur du premier transistor (Q11) est connecté à une alimentation électrique de 9,0 V, un émetteur du premier transistor (Q11) est connecté à un émetteur du deuxième transistor (Q13), un collecteur du deuxième transistor (Q13) est mis à la terre, une base du premier transistor (Q11) est connectée à une base du deuxième transistor (Q13), un port de sortie du troisième amplificateur opérationnel (U7-B) est connecté à la base du premier transistor (Q11) et à la base du deuxième transistor (Q13), le port de sortie du troisième amplificateur opérationnel (U7-B) est connecté à l'émetteur du premier transistor (Q11) et à l'émetteur du deuxième transistor (Q13) via une troisième résistance (R64), l'émetteur du premier transistor (Q11) et l'émetteur du deuxième transistor (Q13) sont connectés à une bobine primaire du transformateur d'isolement (TR1) par le biais d'un condensateur (C11) et d'un inducteur (L3) connectés en série, et la bobine secondaire du transformateur d'isolement (TR1) est connectée à une interface (J3-1).

3. Testeur de chemin de câbles souterrain selon la revendication 1, dans lequel un port de données du module de commande central d'unité primaire est connecté à un commutateur de commande électronique d'unité primaire, le commutateur de commande électronique d'unité primaire comporte un troisième transistor (Q31), un quatrième transistor (Q32), et un cinquième transistor (Q33), des bases du troisième transistor (Q31), du quatrième transistor (Q32) et du cinquième transistor (Q33) sont respectivement connectées à des ports de données du module de commande central d'unité primaire, des émetteurs du troisième transistor (Q31), du quatrième transistor (Q32), et du cinquième transistor (Q33) sont respectivement mis à la terre, et des collecteurs du troisième transistor (Q31), du quatrième transistor (Q32), et du cinquième transistor (Q33) sont respectivement connectés à un port de commande d'un commutateur électronique (U108).

4. Testeur de chemin de câbles souterrain selon la revendication 1, dans lequel l'unité primaire comporte en outre un module de rétroaction de signal, le module de rétroaction de signal comporte un quatrième amplificateur opérationnel (U1), un cinquième amplificateur opérationnel (U9), un sixième amplificateur opérationnel (U12-A), et un septième amplificateur opérationnel (U12-B), le quatrième amplificateur opérationnel (U1), le cinquième amplificateur opérationnel (U9), le sixième amplificateur opérationnel (U12-A), et le septième amplificateur opérationnel (U12-B) sont connectés en séquence pour former un système d'amplification à quatre étages, un port d'entrée de signal du module de rétroaction de signal est connecté à une bobine primaire d'un transformateur d'isolement (TR1), et un port de sortie du module de rétroaction de signal est connecté à un port de données du module de commande central d'unité primaire.

5. Testeur de chemin de câbles souterrain selon la revendication 1, dans lequel le module d'amplification de signal d'axe X comporte un module d'amplification primaire d'axe X et un module d'amplification secondaire d'axe X, le module d'amplification de signal d'axe Y comporte un module d'amplification primaire d'axe Y et un module d'amplification secondaire d'axe Y, le module d'amplification de signal d'axe Z comporte un module d'amplification primaire d'axe Z et un module d'amplification secondaire d'axe Z, la première bobine de réception (L31) est connectée à un port d'entrée du module d'amplification primaire d'axe X, le module d'amplification primaire d'axe X comporte un huitième amplificateur opérationnel (U1-A) et un neuvième amplificateur opérationnel (U1-B), le huitième amplificateur opérationnel (U1-A) et le neuvième amplificateur opérationnel (U1-B) sont connectés pour former un circuit d'amplification à deux étages, le module d'amplification primaire d'axe X est connecté au module d'amplification secondaire d'axe X via une interface (J1), le module d'amplification secondaire d'axe X comporte un dixième amplificateur opérationnel (U8-A) et un onzième amplificateur opérationnel (U8-B), le dixième amplificateur opérationnel (U8-A) et le onzième amplificateur opérationnel (U8-B) sont connectés pour former un circuit d'amplification à deux étages, une branche d'un port de sortie du module d'amplification secondaire d'axe X est connectée à un port de données du module de commande central d'unité secondaire, une autre branche du port de sortie du module d'amplification secondaire d'axe X est connectée à un port d'entrée du module à boucle à verrouillage de phase d'axe X, un port de sortie du module à boucle à verrouillage de phase d'axe X est connecté à un port de données du module de commande central d'unité secondaire, un port de signal d'horloge du module à boucle à verrouillage de phase d'axe X est connecté à un sélecteur de canal d'axe X (U20), et un port de commande du sélecteur de canal d'axe X (U20) est connecté à un port de données du module de commande central d'unité secondaire ;
la deuxième bobine de réception (L32) est connectée à un port d'entrée du module d'amplification primaire d'axe Y, le module d'amplification primaire d'axe Y comporte un douzième amplificateur opérationnel (U2-A) et un treizième amplificateur opérationnel (U2-B), le douzième amplificateur opérationnel (U2-A) et le treizième amplificateur opérationnel (U2-B) sont connectés pour former un circuit d'amplification à deux étages, le module d'amplification primaire d'axe Y est connecté au module d'amplification secondaire d'axe Y via une interface (J1), le module d'amplification secondaire d'axe Y comporte un quatorzième amplificateur opérationnel (U9-A) et un quinzième amplificateur opérationnel (U9-B), le quatorzième amplificateur opérationnel (U9-A) et le quinzième amplificateur opérationnel (U9-B) sont connectés pour former un circuit d'amplification à deux étages, une branche d'un port de sortie du module d'amplification secondaire d'axe Y est connectée à un port de données du module de commande central d'unité secondaire, une autre branche du port de sortie du module d'amplification secondaire d'axe Y est connectée à un port d'entrée du module à boucle à verrouillage de phase d'axe Y, un port de sortie du module à boucle à verrouillage de phase d'axe Y est connecté à un port de données du module de commande central d'unité secondaire, un port de signal d'horloge du module à boucle à verrouillage de phase d'axe Y est connecté à un sélecteur de canal d'axe Y (U13), et un port de commande du sélecteur de canal d'axe Y (U13) est connecté à un port de données du module de commande central d'unité secondaire ; et
la troisième bobine de réception (L33) est connectée à un port d'entrée du module d'amplification primaire d'axe Z, le module d'amplification primaire d'axe Z comporte un seizième amplificateur opérationnel (U3-A) et un dix-septième amplificateur opérationnel (U3-B), le seizième amplificateur opérationnel (U3-A) et le dix-septième amplificateur opérationnel (U3-B) sont connectés pour former un circuit d'amplification à deux étages, le module d'amplification primaire d'axe Z est connecté au module d'amplification secondaire d'axe Z via une interface (J1), le module d'amplification secondaire d'axe Z comporte un dix-huitième amplificateur opérationnel (U10-A) et un dix-neuvième amplificateur opérationnel (U10-B), le dix-huitième amplificateur opérationnel (U10-A) et le dix-neuvième amplificateur opérationnel (U10-B) sont connectés pour former un circuit d'amplification à deux étages, une branche d'un port de sortie du module d'amplification secondaire d'axe Z est connectée à un port de données du module de commande central d'unité secondaire, une autre branche du port de sortie du module d'amplification secondaire d'axe Z est connectée à un port d'entrée du module à boucle à verrouillage de phase d'axe Z, un port de sortie du module à boucle à verrouillage de phase d'axe Z est connecté à un port de données du module de commande central d'unité secondaire, un port de signal d'horloge du module à boucle à verrouillage de phase d'axe Z est connecté à un sélecteur de canal d'axe Z (U10), et un port de commande du sélecteur de canal d'axe Z (U10) est connecté à un port de données du module de commande central d'unité secondaire.

6. Testeur de chemin de câbles souterrain selon la revendication 1, dans lequel l'unité secondaire comporte en outre un module de détection de tension sans fil, le module de détection de tension sans fil comporte une bobine de détection de tension sans contact, un vingtième amplificateur opérationnel (U4-B) et un vingt-et-unième amplificateur opérationnel (U14), la bobine de détection de tension sans contact est connectée à un port d'entrée du vingtième amplificateur opérationnel (U4-B), une sortie du vingtième amplificateur opérationnel (U4-B) est connectée à un port d'entrée du vingt-et-unième amplificateur opérationnel (U14), et un port de sortie du vingt-et-unième amplificateur opérationnel (U14) est connecté à un port de données du module de commande central d'unité secondaire.

7. Testeur de chemin de câbles souterrain selon la revendication 1, dans lequel un port de données du module de commande central d'unité secondaire est connecté à une puce d'amplificateur audio (U15), et un port de sortie de la puce d'amplificateur audio (U15) est connecté à un haut-parleur.

8. Testeur de chemin de câbles souterrain selon la revendication 1, dans lequel un module oscillateur à quartz est connecté entre une interface OSC_IN et une interface OSC_OUT du module de commande central d'unité primaire, et entre une interface OSC_IN et une interface OSC_OUT du module de commande central d'unité secondaire respectivement, un module de réinitialisation à la mise sous tension est connecté à une interface NRST du module de commande central d'unité primaire et à une interface NRST du module de commande central d'unité secondaire respectivement, dans lequel le module de réinitialisation à la mise sous tension comporte un condensateur et une résistance, le condensateur est connecté entre la terre et l'interface NRST du module de commande central correspondant, et la résistance est connectée entre une alimentation électrique positive et l'interface NRST du module de commande central correspondant ;
un module d'affichage est connecté à un port de données du module de commande central d'unité primaire et à un port de données du module de commande central d'unité secondaire respectivement ;
un module de rétroéclairage est connecté au port de données du module de commande central d'unité primaire et au port de données du module de commande central d'unité secondaire respectivement, dans lequel le module de rétroéclairage comporte une première résistance de limitation de courant (R22), un premier commutateur de commande électronique (Q10), et une interface de rétroéclairage (CON2), la première résistance de limitation de courant (R22), l'interface de rétroéclairage (CON2) et le premier commutateur de commande électronique (Q10) sont connectés séquentiellement en série entre l'alimentation électrique positive et la terre, et un port de commande du premier commutateur de commande électronique (Q10) est connecté à un port de données du module de commande central correspondant ;
un module à clé est connecté au port de données du module de commande central d'unité primaire et au port de données du module de commande central d'unité secondaire respectivement, dans lequel le module à clé comporte un premier commutateur à clé (S1), un deuxième commutateur à clé (S2), un troisième commutateur à clé (S3), un quatrième commutateur à clé (S4), un cinquième commutateur à clé (S5), un sixième commutateur à clé (S6), un septième commutateur à clé (S7), et un huitième commutateur à clé (S8), et le premier commutateur à clé (S1), le deuxième commutateur à clé (S2), le troisième commutateur à clé (S3), le quatrième commutateur à clé (S4), le cinquième commutateur à clé (S5), le sixième commutateur à clé (S6), le septième commutateur à clé (S7) et le huitième commutateur à clé (S8) sont connectés entre le port de données du module de commande central correspondant et la terre, respectivement ;
un module d'avertisseur sonore est connecté au port de données du module de commande central d'unité primaire et au port de données du module de commande central d'unité secondaire respectivement, dans lequel le module d'avertisseur sonore comporte un avertisseur sonore et un deuxième commutateur de commande électronique (Q12), l'avertisseur sonore et le deuxième commutateur de commande électronique (Q12) sont connectés en série entre l'alimentation électrique positive et la terre, et un port de commande du deuxième commutateur de commande électronique (Q12) est connecté à un port de données du module de commande central correspondant ; et
un module indicateur de travail est connecté au port de données du module de commande central d'unité primaire et au port de données du module de commande central d'unité secondaire respectivement, dans lequel le module indicateur de travail comporte une deuxième résistance de limitation de courant (R30), une troisième résistance de limitation de courant (R31), une quatrième résistance de limitation de courant (R32), un troisième commutateur de commande électronique (Q9), un premier voyant lumineux (LED1), un deuxième voyant lumineux (LED2), et un troisième voyant lumineux (LED3), la quatrième résistance de limitation de courant (R32) et le premier voyant lumineux (LED1) sont connectés en série, la troisième résistance de limitation de courant (R31) et le deuxième voyant lumineux (LED2) sont connectés en série, la deuxième résistance de limitation de courant (R30) et le troisième voyant lumineux (LED3) sont connectés en série, la quatrième résistance de limitation de courant (R32) et le premier voyant lumineux (LED1) connectés en série, la troisième résistance de limitation de courant (R31) et le deuxième voyant lumineux (LED2) connectés en série, et la deuxième résistance de limitation de courant (R30) et le troisième voyant lumineux (LED3) connectés en série sont connectés en parallèle et sont connectés entre l'alimentation électrique positive et la terre via le troisième commutateur de commande électronique (Q9), et un port de commande du troisième commutateur de commande électronique (Q9) est connecté à un port de données du module de commande central correspondant.

9. Testeur de chemin de câbles souterrain selon la revendication 1, dans lequel le module de puissance d'unité primaire comporte une interface USB d'unité primaire, un module de gestion de charge d'unité primaire, une batterie au lithium d'unité primaire et un dispositif de gestion de puissance d'unité primaire, l'interface USB d'unité primaire est connectée à un port d'entrée de puissance du module de gestion de charge d'unité primaire, la batterie au lithium d'unité primaire est connectée à un port de sortie de puissance du module de gestion de charge d'unité primaire, et la batterie au lithium de l'unité primaire est chargée via l'interface USB d'unité primaire ;
une électrode positive de la batterie au lithium d'unité primaire est connectée à un module de détection de tension de batterie d'unité primaire, le module de détection de tension de batterie d'unité primaire comporte deux résistances connectées en série, et une extrémité commune entre deux résistances est connectée à un port de données du module de commande central d'unité primaire ; lorsque le premier dispositif de traitement de signal est le module de transmission de signal, une électrode positive de la batterie au lithium d'unité secondaire est connectée à un module de détection de tension de batterie d'unité secondaire, le module de détection de tension de batterie d'unité secondaire comporte deux résistances connectées en série, et une extrémité commune entre deux résistances est connectée à un port de données du module de commande central d'unité secondaire ; lorsque le premier dispositif de traitement de signal est un module de transmission de signal, le dispositif de gestion de puissance d'unité primaire comporte une puce de suralimentation d'unité primaire (U105) et une puce de régulateur de tension d'unité primaire (U104), un port d'entrée de puissance de la puce de suralimentation d'unité primaire (U105) est connecté à la batterie au lithium d'unité primaire, une tension de la batterie au lithium d'unité primaire est convertie en + 9,0 V pour l'alimentation électrique via la puce de suralimentation d'unité primaire (U105), et une tension de + 9,0 V est régulée à + 3,3 V via la puce du régulateur de tension d'unité primaire (U104) puis émise vers l'unité primaire pour l'alimentation électrique.

10. Testeur de chemin de câbles souterrain selon la revendication 1, dans lequel : le module de puissance d'unité secondaire comporte une interface USB d'unité secondaire, un module de gestion de charge d'unité secondaire, une batterie au lithium d'unité secondaire et un dispositif de gestion de puissance d'unité secondaire, l'interface USB d'unité secondaire est connectée à un port d'entrée de puissance du module de gestion de charge d'unité secondaire, la batterie au lithium d'unité secondaire est connectée à un port de sortie de puissance du module de gestion de charge d'unité secondaire, et la batterie au lithium d'unité secondaire est chargée via l'interface USB d'unité secondaire ;
le dispositif de gestion de puissance d'unité secondaire comporte une puce MOSFET (Q106), une puce de suralimentation d'unité secondaire (U102), une première puce de régulateur de tension d'unité secondaire (U114), et une deuxième puce de régulateur de tension d'unité secondaire (U116), un port d'entrée de puissance de la puce de suralimentation d'unité secondaire (U102) est connecté à la batterie au lithium d'unité secondaire via la puce MOSFET (Q106), une tension de la batterie au lithium d'unité secondaire est convertie en + 9,0 V pour l'alimentation électrique via la puce de suralimentation d'unité secondaire (U102), une tension de + 9,0 V est régulée à + 5,0 V via la première puce de régulateur de tension d'unité secondaire (U114) puis émise vers l'unité secondaire pour l'alimentation électrique, et une tension de la batterie au lithium d'unité secondaire est régulée à + 3,3 V via la deuxième puce de régulateur de tension d'unité secondaire (U116) puis émise vers l'unité secondaire pour l'alimentation électrique.
